# EUROPEAN PATENT SPECIFICATION

(11) **EP 4 404 718 B1**
(45) Date of publication and mention of the grant of the patent: **24.12.2025**
(21) Application number: 23195036.1
(22) Date of filing: 04.09.2023
(51) Int. Cl.: H10K 85/60, H10K 50/19, H10K 50/11

(54) **ORGANIC LIGHT EMITTING DIODE AND ORGANIC LIGHT EMITTING DEVICE**
ORGANISCHE LEUCHTDIODE UND ORGANISCHE LICHTEMITTIERENDE VORRICHTUNG
DIODE ÉLECTROLUMINESCENTE ORGANIQUE ET DISPOSITIF ÉLECTROLUMINESCENT ORGANIQUE

(30) Priority: 17.01.2023 KR 20230006705
(43) Date of publication of application: 24.07.2024
(73) Proprietor: LG Display Co., Ltd., Seoul 07336 (KR)
(72) Inventor: Lee, Yu-Jeong, 10845 Paju-si (KR); Cho, Hyun-Jin, 10845 Paju-si (KR); Park, Eun-Jung, 10845 Paju-si (KR); Kwon, Ju-Hyuk, 10845 Paju-si (KR); Youn, Jang-Dae, 10845 Paju-si (KR); Jeong, Shin-Young, 10845 Paju-si (KR); Ha, Jun-Su, 10845 Paju-si (KR)
(74) Representative: Ter Meer Steinmeister & Partner

(56) References cited:
- KR-A- 20190 139 792
- US-A1- 2021 184 152
- US-A1- 2021 320 273
- US-A1- 2021 384 436
- US-A1- 2022 393 113
- HYOUNGCHEOL LIM: "Breaking the Efficiency Limit of Deep-Blue Fluorescent OLEDs Based on Anthracene Derivatives", vol. 34, no. 1, 23 October 2021 (2021-10-23), DE, XP093160905, ISSN: 0935-9648, Retrieved from the Internet <URL:https://onlinelibrary.wiley.com/doi/full-xml/10.1002/adma.202100161> DOI: 10.1002/adma.202100161

## Description

### BACKGROUND

### Technical Field

The present invention relates to an organic light emitting diode, and more particularly to, an organic light emitting diode (OLED) that has low power consumption, improved luminous efficiency and/or luminous lifespan, as well as to an organic light emitting device including the OLED (*e.g.*, a display device or a lighting device).

### Description of the Related Art

Flat panel display devices including an organic light emitting diode (OLED), have been investigated as display devices that can replace a liquid crystal display device (LCD). The OLED can be formed as a thin organic film less than 2000 Å and the electrode configurations can implement unidirectional or bidirectional images. Also, the OLED can be formed even on a flexible transparent substrate such as a plastic substrate so that a flexible or a foldable display device can be realized with ease using the OLED. In addition, the OLED can be driven at a lower voltage and the OLED has advantageous high color purity compared to the LCD.

However, there remains a need to develop OLEDs and devices thereof that have improved luminous efficiency and luminous lifespan. Since fluorescent materials use only singlet excitons in the luminous process, the related art fluorescent material shows low luminous efficiency. Meanwhile, phosphorescent materials can show high luminous efficiency since they use triplet exciton as well as singlet excitons in the luminous process. But, examples of such phosphorescent material include metal complexes, which can have a short luminous lifespan for commercial use. Examples of blue light emitting OLEDs comprising two hosts in the light emitting layer, the host materials being anthracene derivatives, are described in KR20190139792 and US2021320273. As such, there remains a need to develop an OLED with sufficient luminous efficiency, luminous lifespan and color purity.

### SUMMARY OF THE INVENTION

Accordingly, embodiments of the present invention are directed to an organic light emitting diode and an organic light emitting device that substantially obviate one or more of the problems due to the limitations and disadvantages of the related art.

An aspect of the present invention is to provide an organic light emitting diode that can implement low power consumption and has beneficial luminous efficiency and luminous lifespan, as well as an organic light emitting device including the diode.

Additional features and aspects will be set forth in the description that follows, and in part will be apparent from the description, or can be learned by practice of the disclosed concepts provided herein. Other features and aspects of the disclosed concept can be realized and attained by the structure particularly pointed out in the written description, or derivable therefrom, and the claims hereof as well as the appended drawings.

To achieve these and other advantages and in accordance with objects of the invention, as embodied and broadly described herein, in a first aspect, the present invention provides an organic light emitting diode that according to claim 1. Such an OLED includes a first electrode; a second electrode facing the first electrode; and an emissive layer disposed between the first and second electrode, and including at least one blue emitting material layer. The blue emitting material layer in some OLEDs not falling under the invention may include a first host having the following structure of Chemical Formula 1 and a second host having the following structure of Chemical Formula 3: 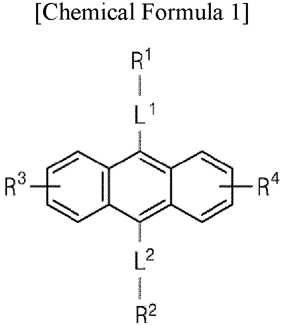
wherein, in the Chemical Formula 1,
each of R¹ and R² is independently an unsubstituted or substituted C₆-C₃₀ aryl group,
each of R³ and R⁴ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
each of L¹ and L² is independently a single bond, an unsubstituted or substituted C₆-C₃₀ arylene group or an unsubstituted or substituted C₃-C₃₀ hetero arylene group, 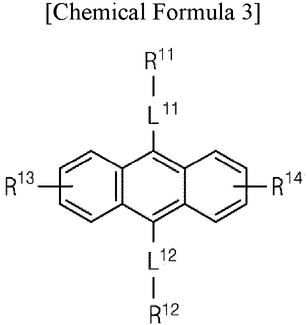
wherein, in the Chemical Formula 3,
each of R¹¹ and R¹² is independently an unsubstituted or substituted C₆-C₃₀ aryl group or an unsubstituted or substituted C₃-C₃₀ hetero aryl group, where at least one of R¹¹ and R¹² is the unsubstituted or substituted C₃-C₃₀ hetero aryl group;
each of R¹³ and R¹⁴ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
each of L¹¹ and L¹² is independently a single bond, an unsubstituted or substituted C₆-C₃₀ arylene group or an unsubstituted or substituted C₃-C₃₀ hetero arylene group.

In the Chemical Formula 1, R¹ is an unsubstituted or substituted naphthalene, or phenanthrene group; R² is an unsubstituted or substituted naphthalene group; each of R³ and R⁴ is independently hydrogen, deuterium, methyl, ethyl or propyl; and each of L¹ and L² is independently a single bond or an unsubstituted or substituted phenyl group, and wherein in the Chemical Formula 3, R¹¹ is an unsubstituted or substituted naphthalene, or phenanthrene group; R¹² is independently an unsubstituted or substituted dibenzofuran, or carbazole group; each of R¹³ and R¹⁴ is independently hydrogen, deuterium, methyl, ethyl or propyl; and each of L¹¹ and L¹² is independently a single bond or an unsubstituted or substituted phenyl group.

In the Chemical Formula 1, each of R¹ and R² is independently an unsubstituted or substituted dibenzofuran, carbazole, naphthalene, or phenanthrene group; each of R³ and R⁴ is independently hydrogen, deuterium, methyl, ethyl or propyl; and each of L¹ and L² is independently a single bond or an unsubstituted or substituted phenyl group, and wherein in the Chemical Formula 3, each of R¹¹ and R¹² is independently an unsubstituted or substituted dibenzofuran, carbazole, naphthalene, or phenanthrene group; each of R¹³ and R¹⁴ is independently hydrogen, deuterium, methyl, ethyl or propyl; and each of L¹¹ and L¹² is independently a single bond, an unsubstituted or substituted C₆-C₃₀ arylene group or an unsubstituted or a phenyl group.

According to the invention, the first host is at least one of the following organic compounds BH1-2 to BH1-8:

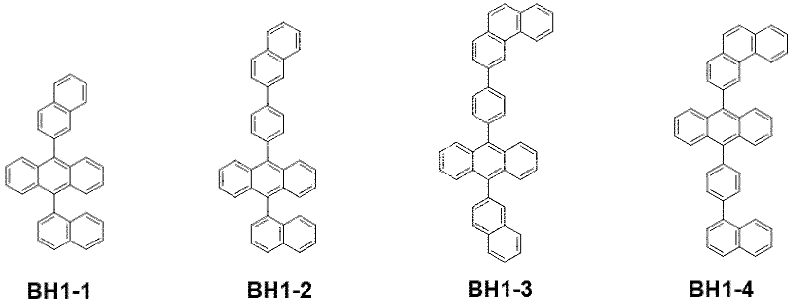

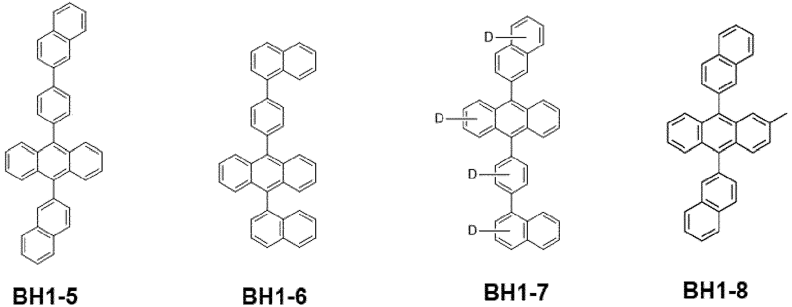

According to the invention, the second host is at least one of the following organic compounds BH2-2 to BH2-7:

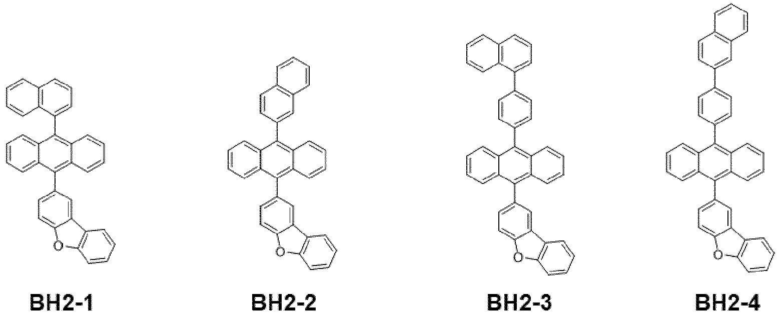

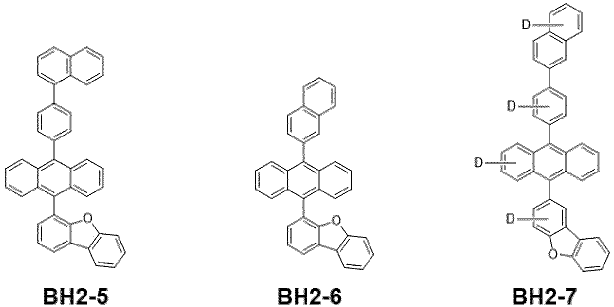

The first host and the second host in the at least one blue emitting material layers are admixed with a weight ratio of about 9:1 to about 7:3. In other aspects, the first host and the second host in the at least one blue emitting material layers can be admixed with a weight ratio of about 8:2 or about 6:4.

The first host can have a highest occupied molecular orbital (HOMO) energy level lower than a HOMO energy level of the second host.

In one embodiment, the first host has a HOMO energy level between about -5.9 eV and about -6.1 eV and/or the second host has a HOMO energy level between about -5.8 eV and about -5.9 eV.
in one embodiment, the emissive layer can further include at least one hole transport layer or at least one electron blocking layer disposed between the first electrode and the at least one blue emitting material layer, wherein an energy bandgap between a HOMO energy level of hole transporting material in the at least one hole transport layer or electron blocking material in the at least one electron blocking layer, and a HOMO energy level of at least one of the first host and the second host in the at least one blue emitting material layer can be about 0.15 eV or less.

In an embodiment, the emissive layer can further include a first emitting part disposed between the first electrode and the second electrode, and including a first blue emitting material layer; a second emitting part disposed between the first emitting part and the second electrode; a third emitting part disposed between the second emitting part and the second electrode, and including a second blue emitting material layer; a first charge generation layer disposed between the first emitting part and the second emitting part; and a second charge generation layer disposed between the second emitting part and the third emitting part, wherein at least one of the first blue emitting material layer and the second blue emitting material layer can include the first host and the second host.

Furthermore, there is provided an organic light emitting device, for example, an organic light emitting display device or an organic light emitting illumination device, that includes a substrate and the organic light emitting diode over the substrate.

The at least one blue emitting material layer includes the first host and the second host, each of which is an anthracene-based organic compound. The at least one blue emitting material includes the second host of which HOMO energy level is relatively low compared to the HOMO energy level of the first host, so that the HOMO energy bandgap between the HOMO energy level of the at least one blue emitting material layer, and the HOMO energy level of the hole transport layer and/or the electron blocking layer disposed adjacently to the at least one blue emitting material layer is optimized.

In one or more embodiments, the energy barrier for the hole injection between the at least one blue emitting material layer and the hole transport layer and/or the electron blocking layer disposed adjacently to the at least one blue emitting material layer becomes minimal. Holes generated at the anode or the P-type charge generation layer can be injected rapidly into the at least blue emitting material layer from the hole transport layer and/or the electron blocking layer without accumulating at an interface between the at least one blue emitting material layer and the hole transport layer and/or the electron blocking layer. In particular, the HOMO energy barrier between the blue emitting material layer disposed in the blue emitting unit into which holes are injected from the P-type charge generation layer and the hole transport layer and/or the electron blocking layer disposed adjacently to the blue emitting material layer within the blue emitting unit is optimized.

In one or more embodiments, since the holes are not accumulated at the interface between the at least one blue emitting material layer and the hole transporting layer and/or electron blocking layer, it is possible to prevent hole transporting material and/or electron blocking material from deteriorated owing to the accumulated holes. The driving voltage of the organic light emitting diode can be lowered, and thus the luminous lifespan of the organic light emitting diode can be improved with low power consumption in the embodiments of the present invention.

In addition, holes injected into the at least one blue emitting material layer can be recombined with electrons to form excitons efficiently as holes are injected rapidly into the at least blue emitting material layer, and therefore, the luminous efficiency of the organic light emitting diode can be improved in the embodiments of the present invention.

Therefore, it is possible to realize an organic light emitting diode and an organic light emitting device with low driving voltage and low power consumption as well as beneficial luminous efficiency and luminous lifespan in the embodiments of the present invention.

It is to be understood that both the foregoing general description and the following detailed description are merely by way of example and are intended to provide further explanation of the inventive concepts as claimed.

### BRIEF DESCRIPTION OF THE DRAWINGS

The accompanying drawings, which are included to provide a further understanding of the invention, are incorporated in and constitute a part of this application, illustrate embodiments of the invention and together with the description serve to explain principles of the invention.
FIG. 1 illustrates a schematic circuit diagram of an organic light emitting display device according to one or more embodiments of the present invention.
FIG. 2 illustrates a cross-sectional view of an organic light emitting display device as an example of an organic light emitting device in accordance with an example embodiment of the present invention.
FIG. 3 illustrates a cross-sectional view of an organic light emitting diode having a single emitting part in accordance with an example embodiment of the present invention.
FIG. 4 illustrates a schematic diagram showing energy levels among a common layer and a blue emitting material layer in a conventional organic light emitting diode with a single emitting unit.
FIG. 5 illustrates a schematic diagram showing energy levels among a common layer and a blue emitting material layer in an organic light emitting diode with a single emitting unit in accordance with an example embodiment of the present invention.
FIG. 6 illustrates a cross-sectional view of an organic light emitting display device in accordance with another example embodiment of the present invention.
FIG. 7 illustrates a cross-sectional view of an organic light emitting diode having a tandem structure of multiple emitting parts in accordance with another example embodiment of the present invention.
FIG. 8 illustrates a schematic diagram showing energy levels among a common layer and a blue emitting material layer of the emitting unit adjacently to the cathode in a conventional organic light emitting diode with a tandem structure.
FIG. 9 illustrates a schematic diagram showing energy levels among a common layer and a blue emitting material layer of the emitting unit adjacently to the cathode in an organic light emitting diode with a tandem structure in accordance with an example embodiment of the present invention.

### DETAILED DESCRIPTION OF THE EMBODIMENTS

Reference will now be made in detail to aspects of the invention, examples of which are illustrated in the accompanying drawings. Wherever possible, the same reference numbers will be used throughout the drawings to refer to the same or like parts. In the following description, when a detailed description of well-known functions or configurations related to this document is determined to unnecessarily cloud a gist of the inventive concept, the detailed description thereof will be or may be omitted. The progression of processing steps and/or operations described is an example; however, the sequence of steps and/or operations is not limited to that set forth herein and can be changed as is known in the art, with the exception of steps and/or operations necessarily occurring in a particular order. Names of the respective elements used in the following explanations are selected only for convenience of writing the specification and can be thus different from those used in actual products. Further, all the components of each organic light emitting diode (OLED) and each organic light emitting device (e.g., display device, illumination device, etc.) using the OLED according to all embodiments of the present invention are operatively coupled and configured.

The present invention relates to an organic light emitting diode and/or an organic light emitting device that can minimize the energy barrier for the hole injection between the at least one blue emitting material layer and the common layer disposed adjacently to the at least one blue emitting material layer in an emissive layer, and therefore, can lower driving voltage for the low power consumption and improve the luminous efficiency and luminous lifespan.

As an example, in one or more embodiments of the present invention, the emissive layer can be applied into an organic light emitting diode with a single emitting unit in a blue pixel region. Alternatively, the emissive layer can be applied into an organic light emitting diode where multiple emitting parts are stacked to form a tandem-structure. The organic light emitting diode can be applied to an organic light emitting device such as an organic light emitting display device or an organic light emitting illumination device.

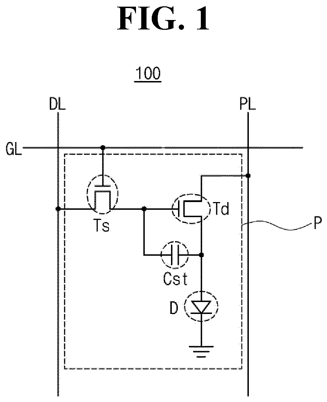

FIG. 1 illustrates a schematic circuit diagram of an organic light emitting display device in accordance with one or more embodiments of the present invention.

As illustrated in FIG. 1, a gate line GL, a data line DL and a power line PL, each of which crosses each other to define a pixel region P, are provided in an organic light emitting display device 100. A switching thin film transistor Ts, a driving thin film transistor Td, a storage capacitor Cst and an organic light emitting diode D are disposed within the pixel region P. The pixel region P can include a red (R) pixel region, a green (G) pixel region and a blue (B) pixel region. However, embodiments of the present invention are not limited to such examples. The organic light emitting display device 100 includes a plurality of such pixel regions P which can be arranged in a matrix configuration or other configurations.

The switching thin film transistor Ts is connected to the gate line GL and the data line DL. The driving thin film transistor Td and the storage capacitor Cst are connected between the switching thin film transistor Ts and the power line PL. The organic light emitting diode D is connected to the driving thin film transistor Td. When the switching thin film transistor Ts is turned on by a gate signal applied to the gate line GL, a data signal applied to the data line DL is applied to a gate electrode of the driving thin film transistor Td and one electrode of the storage capacitor Cst through the switching thin film transistor Ts.

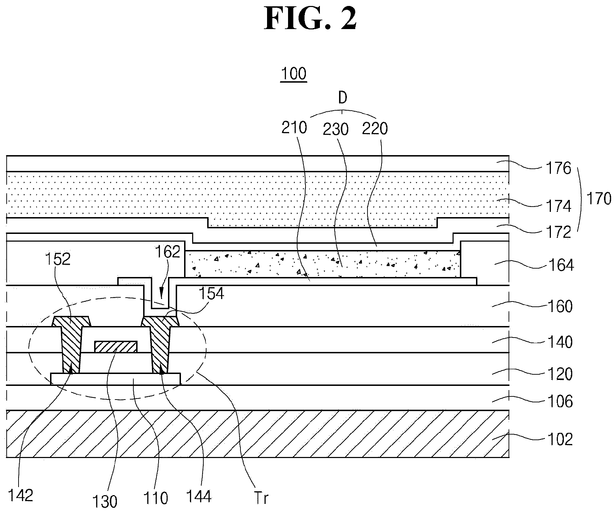

The driving thin film transistor Td is turned on by the data signal applied to a gate electrode 130 (FIG. 2) so that a current proportional to the data signal is supplied from the power line PL to the organic light emitting diode D through the driving thin film transistor Td. And then, the organic light emitting diode D emits light having a luminance proportional to the current flowing through the driving thin film transistor Td. In this case, the storage capacitor Cst is charged with a voltage proportional to the data signal so that the voltage of the gate electrode in the driving thin film transistor Td is kept constant during one frame. Therefore, the organic light emitting display device can display a desired image.

FIG. 2 illustrates a schematic cross-sectional view of an organic light emitting display device in accordance with an embodiment of the present invention. The pixel circuit configuration of FIG. 1 can be used in the display device of FIG. 2 or other figures of the present application.

As illustrated in FIG. 2, the organic light emitting display device 100 includes a substrate 102, a thin-film transistor Tr on the substrate 102, and an organic light emitting diode D connected to the thin film transistor Tr. As an example, the substrate 102 can include a red pixel region, a green pixel region and a blue pixel region and an organic light emitting diode D can be located in each pixel region. Each of the organic light emitting diodes D emitting red, green and blue light, respectively, is located correspondingly in the red pixel region, the green pixel region and the blue pixel region. For example, the organic light emitting diode D can be disposed in the blue pixel region.

The substrate 102 can include, but is not limited to, glass, thin flexible material and/or polymer plastics. For example, the flexible material can be selected from the group, but is not limited to, polyimide (PI), polyethersulfone (PES), polyethylenenaphthalate (PEN), polyethylene terephthalate (PET), polycarbonate (PC) and/or combinations thereof. The substrate 102, on which the thin film transistor Tr and the organic light emitting diode D are arranged, forms an array substrate.

A buffer layer 106 can be disposed on the substrate 102. The thin film transistor Tr can be disposed on the buffer layer 106. In certain embodiments, the buffer layer 106 can be omitted.

A semiconductor layer 110 is disposed on the buffer layer 106. In one embodiment, the semiconductor layer 110 can include, but is not limited to, oxide semiconductor materials. In this case, a light-shield pattern can be disposed under the semiconductor layer 110, and the light-shield pattern can prevent light from being incident toward the semiconductor layer 110, thereby, preventing or reducing the semiconductor layer 110 from being degraded by the light. Alternatively, the semiconductor layer 110 can include polycrystalline silicon. In this case, opposite edges of the semiconductor layer 110 can be doped with impurities.

A gate insulating layer 120 including an insulating material is disposed on the semiconductor layer 110. The gate insulating layer 120 can include, but is not limited to, an inorganic insulating material such as silicon oxide (SiOₓ, wherein 0 < x ≤ 2) or silicon nitride (SiNₓ, wherein 0 < x ≤ 2).

A gate electrode 130 made of a conductive material such as a metal is disposed on the gate insulating layer 120 so as to correspond to a center of the semiconductor layer 110. While the gate insulating layer 120 is disposed on the entire area of the substrate 102 as shown in FIG. 2, the gate insulating layer 120 can be patterned identically as the gate electrode 130.

An interlayer insulating layer 140 including an insulating material is disposed on the gate electrode 130 and covers an entire surface of the substrate 102. The interlayer insulating layer 140 can include, but is not limited to, an inorganic insulating material such as silicon oxide (SiOₓ) or silicon nitride (SiNₓ), or an organic insulating material such as benzocyclobutene or photo-acryl.

The interlayer insulating layer 140 has first and second semiconductor layer contact holes 142 and 144 that expose or do not cover a portion of the surface nearer to the opposing ends than to a center of the semiconductor layer 110. The first and second semiconductor layer contact holes 142 and 144 are disposed on opposite sides of the gate electrode 130 and spaced apart from the gate electrode 130. The first and second semiconductor layer contact holes 142 and 144 are formed within the gate insulating layer 120 in FIG. 2. Alternatively, in certain embodiments, the first and second semiconductor layer contact holes 142 and 144 can be formed only within the interlayer insulating layer 140 when the gate insulating layer 120 is patterned identically as the gate electrode 130.

A source electrode 152 and a drain electrode 154, which are made of conductive material such as a metal, are disposed on the interlayer insulating layer 140. The source electrode 152 and the drain electrode 154 are spaced apart from each other on opposing sides of the gate electrode 130, and contact both sides of the semiconductor layer 110 through the first and second semiconductor layer contact holes 142 and 144, respectively.

The semiconductor layer 110, the gate electrode 130, the source electrode 152 and the drain electrode 154 constitute the thin film transistor Tr, which acts as a driving element. The thin film transistor Tr in FIG. 2 has a coplanar structure in which the gate electrode 130, the source electrode 152 and the drain electrode 154 are disposed on the semiconductor layer 110. Alternatively, the thin film transistor Tr can have an inverted staggered structure in which a gate electrode is disposed under a semiconductor layer and a source and drain electrodes are disposed on the semiconductor layer. In this case, the semiconductor layer can include amorphous silicon.

The gate line GL and the data line DL, which cross each other to define a pixel region P, and a switching element Ts, which is connected to the gate line GL and the data line DL, can be further formed in the pixel region P. The switching element Ts is connected to the thin film transistor Tr, which is a driving element. In addition, the power line PL is spaced apart in parallel from the gate line GL or the data line DL. The thin film transistor Tr can further include a storage capacitor Cst configured to constantly keep a voltage of the gate electrode 130 for one frame.

A passivation layer 160 is disposed on the source and drain electrodes 152 and 154. The passivation layer 160 covers the thin film transistor Tr on the entire substrate 102. The passivation layer 160 has a flat top surface and a drain contact hole (or a contact hole) 162 that exposes or does not cover the drain electrode 154 of the thin film transistor Tr. While the drain contact hole 162 is disposed on the second semiconductor layer contact hole 144, it can be spaced apart from the second semiconductor layer contact hole 144.

The organic light emitting diode (OLED) D includes a first electrode 210 that is disposed on the passivation layer 160 and connected to the drain electrode 154 of the thin film transistor Tr. The OLED D further includes an emissive layer 230 and a second electrode 220 each of which is disposed sequentially on the first electrode 210.

The first electrode 210 is disposed in each pixel region P. The first electrode 210 can be an anode and include conductive material having relatively high work function value. For example, the first electrode 210 can include a transparent conductive oxide (TCO).

In one embodiment, when the organic light emitting display device 100 is a bottom-emission type, the first electrode 210 can have a single-layered structure of the TCO. Alternatively, when the organic light emitting display device 100 is a top-emission type, a reflective electrode or a reflective layer can be disposed under the first electrode 210. For example, the reflective electrode or the reflective layer can include, but is not limited to, silver (Ag) or aluminum-palladium-copper (APC) alloy. In the OLED D of the top-emission type, the first electrode 210 can have a triple-layered structure of ITO/Ag/ITO or ITO/APC/ITO.

In addition, a bank layer 164 is disposed on the passivation layer 160 in order to cover edges of the first electrode 210. The bank layer 164 exposes or does not cover a center of the first electrode 210 corresponding to each pixel region. In certain embodiments, the bank layer 164 can be omitted.

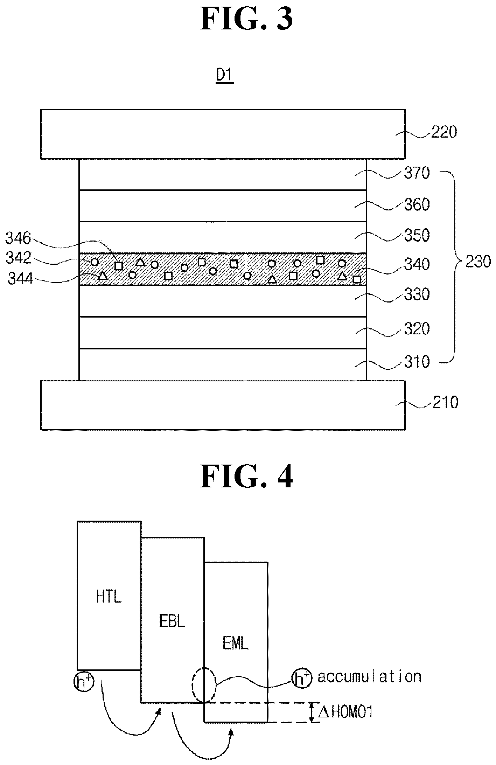

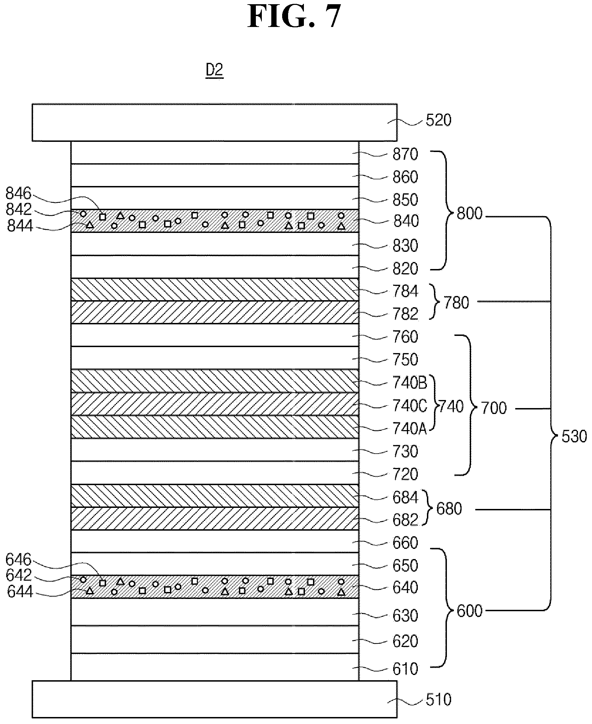

The emissive layer 230 is disposed on the first electrode 210. In one embodiment, the emissive layer 230 can have a single-layered structure of an emitting material layer (EML). Alternatively, the emissive layer 230 can have a multiple-layered structure of a hole injection layer (HIL), a hole transport layer (HTL), an electron blocking layer (EBL), an EML, a hole blocking layer (HBL), an electron transport layer (ETL), an electron injection layer (EIL) and/or a charge generation layer (CGL) (FIGS. 3 and 7).

In one aspect, the emissive layer 230 can have a single emitting part. Alternatively, the emissive layer 230 can have multiple emitting parts to form a tandem structure. For example, the emissive layer 230 can be applied to an organic light emitting diode having a single emissive layer disposed in each of the red pixel region, the green pixel region and the blue pixel region, respectively. Alternatively, the emissive layer 230 can be applied to an organic light emitting diode of a tandem structure stacked multiple emitting parts.

The second electrode 220 is disposed on the substrate 102 above which the emissive layer 230 is disposed. The second electrode 220 can be disposed on the entire display area. The second electrode 220 can include a conductive material with a relatively low work function value compared to the first electrode 210. The second electrode 220 can be a cathode providing electrons.

In addition, an encapsulation film 170 can be disposed on the second electrode 220 in order to prevent or reduce outer moisture from penetrating into the OLED D. The encapsulation film 170 can have, but is not limited to, a laminated structure of a first inorganic insulating film 172, an organic insulating film 174 and a second inorganic insulating film 176. In certain embodiments, the encapsulation film 170 can be omitted.

A polarizing plate can be attached onto the encapsulation film 170 to reduce reflection of external light. For example, the polarizing plate can be a circular polarizing plate. When the organic light emitting display device 100 is a bottom-emission type, the polarizing plate can be disposed under the substrate 102. Alternatively, when the organic light emitting display device 100 is a top-emission type, the polarizing plate can be disposed on the encapsulation film 170. In addition, a cover window can be attached to the encapsulation film 170 or the polarizing plate. In this case, the substrate 102 and the cover window can have a flexible property, thus the organic light emitting display device 100 can be a flexible display device.

The OLED D is described in more detail. FIG. 3 illustrates a schematic cross-sectional view of an organic light emitting diode having a single emitting part in accordance with an embodiment of the present invention. For instance, FIG. 3 shows an example (OLED D1) of the OLED D in FIGS. 1 and 2.

As illustrated in FIG. 3, the organic light emitting diode (OLED) D1 in accordance with an example of the present invention includes first and second electrodes 210 and 220 facing each other and an emissive layer 230 disposed between the first and second electrodes 210 and 220. The organic light emitting display device 100 includes a red pixel region, a green pixel region and a blue pixel region, and the OLED D1 can be disposed in the blue pixel region.

In an embodiment, the emissive layer 230 includes an emitting material layer (EML) 340 disposed between the first and second electrodes 210 and 220. The EML 340 can be a blue emitting material layer.

The emissive layer 230 can include at least one of a hole transport layer (HTL) 320 disposed between the first electrode 210 and the EML 340 and an electron transport layer (ETL) 360 disposed between the second electrode 220 and the EML 340. In certain embodiments, the emissive layer 230 can further include at least one of a hole injection layer (HIL) 310 disposed between the first electrode 210 and the HTL 320 and an electron injection layer (EIL) 370 disposed between the second electrode 220 and the ETL 360. Alternatively, the emissive layer 230 can further comprise a first exciton blocking layer, *i.e.* an electron blocking layer (EBL) 330 disposed between the HTL 320 and the EML 340 and/or a second exciton blocking layer, *i.e.* a hole blocking layer (HBL) 350 disposed between the EML 340 and the ETL 360. In an alternative embodiment, a second hole transport layer (HTL2) in place of the EBL 330 can be disposed.

The first electrode 210 can be an anode that provides a hole into the EML 340. The first electrode 210 can include a conductive material having a relatively high work function value, for example, a transparent conductive oxide (TCO). In an embodiment, the first electrode 210 can include, but is not limited to, indium tin oxide (ITO), indium zinc oxide (IZO), indium tin zinc oxide (ITZO), tin oxide (SnO), zinc oxide (ZnO), indium cerium oxide (ICO), aluminum doped zinc oxide (AZO), and/or combinations thereof.

The second electrode 220 can be a cathode that provides an electron into the EML 340. The second electrode 220 can include a conductive material having a relatively low work function value. For example, the second electrode 220 can include highly reflective material such as aluminum (Al), magnesium (Mg), calcium (Ca), silver (Ag), alloy thereof and/or combinations thereof such as aluminum-magnesium alloy (Al-Mg). When the organic light emitting display device 100 is a top-emission type, the second electrode 220 is thin so as to have light-transmissive (semi-transmissive) property.

The EML 340 includes a host including a first host 342 and a second host 344 and a blue emitter (blue dopant) 346 where the substantial light emission is occurred.

Each of the first host 342 and the second host 344 is an anthracene-based organic compound, respectively. The first host 342 has a highest occupied molecular orbital (HOMO) energy level relatively high compared to HOMO energy level of the second host 344. Generally, a first host 342 can be an anthracene-based organic compound having the following structure of Chemical Formula 1: 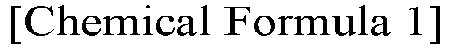 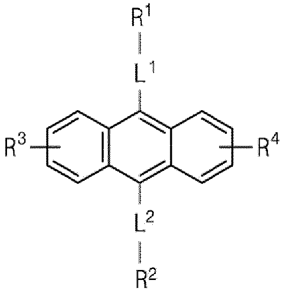 wherein, in the Chemical Formula 1,
each of R¹ and R² is independently an unsubstituted or substituted C₆-C₃₀ aryl group,
each of R³ and R⁴ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
each of L¹ and L² is independently a single bond, an unsubstituted or substituted C₆-C₃₀ arylene group or an unsubstituted or substituted C₃-C₃₀ hetero arylene group.

As used herein, the term "unsubstituted" means that hydrogen is directly linked to a carbon atom. "Hydrogen", as used herein, can refer to protium, deuterium and tritium.

As used herein, "substituted" means that the hydrogen is replaced with a substituent. The substituent can comprise, but is not limited to, an unsubstituted or halogen-substituted C₁-C₂₀ alkyl group, an unsubstituted or halogen-substituted C₁-C₂₀ alkoxy, halogen, a cyano group, a hydroxyl group, a carboxylic group, a carbonyl group, an amino group, a C₁-C₁₀ alkyl amino group, a C₆-C₃₀ aryl amino group, a C₃-C₃₀ hetero aryl amino group, a nitro group, a hydrazyl group, a sulfonate group, a C₁-C₁₀ alkyl silyl group, a C₁-C₁₀ alkoxy silyl group, a C₃-C₂₀ cyclo alkyl silyl group, a C₆-C₃₀ aryl silyl group, a C₃-C₃₀ hetero aryl silyl group, an unsubstituted or substituted C₆-C₃₀ aryl group, an unsubstituted or substituted C₃-C₃₀ hetero aryl group.

As used herein, the term "hetero" in terms such as "a hetero aryl group", and "a hetero arylene group" and the likes means that at least one carbon atom, for example 1 to 5 carbons atoms, constituting an aliphatic chain, an alicyclic group or ring or an aromatic group or ring is substituted with at least one hetero atom selected from the group consisting of N, O, S and P.

The aryl group can independently include, but is not limited to, an unfused or fused aryl group such as phenyl, biphenyl, terphenyl, naphthyl, anthracenyl, pentalenyl, indenyl, indeno-indenyl, heptalenyl, biphenylenyl, indacenyl, phenalenyl, phenanthrenyl, benzo-phenanthrenyl, dibenzo-phenanthrenyl, azulenyl, pyrenyl, fluoranthenyl, triphenylenyl, chrysenyl, tetraphenylenyl, tetracenyl, pleiadenyl, picenyl, pentaphenylenyl, pentacenyl, fluorenyl, indeno-fluorenyl or spiro-fluorenyl.

The hetero aryl group can independently include, but is not limited to, an unfused or fused hetero aryl group such as pyrrolyl, pyridinyl, pyrimidinyl, pyrazinyl, pyridazinyl, triazinyl, tetrazinyl, imidazolyl, pyrazolyl, indolyl, iso-indolyl, indazolyl, indolizinyl, pyrrolizinyl, carbazolyl, benzo-carbazolyl, dibenzo-carbazolyl, indolo-carbazolyl, indeno-carbazolyl, benzofuro-carbazolyl, benzo-thieno-carbazolyl, carbolinyl, quinolinyl, iso-quinolinyl, phthlazinyl, quinoxalinyl, cinnolinyl, quinazolinyl, quinolizinyl, purinyl, benzo-quinolinyl, benzo-iso-quinolinyl, benzo-quinazolinyl, benzo-quinoxalinyl, acridinyl, phenazinyl, phenoxazinyl, phenothiazinyl, phenanthrolinyl, perimidinyl, phenanthridinyl, pteridinyl, naphthyridinyl, furanyl, pyranyl, oxazinyl, oxazolyl, oxadiazolyl, triazolyl, dioxinyl, benzo-furanyl, dibenzo-furanyl, thiopyranyl, xanthenyl, chromenyl, iso-chromenyl, thioazinyl, thiophenyl, benzo-thiophenyl, dibenzo-thiophenyl, difuro-pyrazinyl, benzofuro-dibenzo-furanyl, benzothieno-benzo-thiophenyl, benzothieno-dibenzo-thiophenyl, benzothieno-benzo-furanyl, benzothieno-dibenzo-furanyl, xanthene-linked spiro acridinyl, dihydroacridinyl substituted with at least one C₁-C₁₀ alkyl and N-substituted spiro fluorenyl.

As an example, each of the aryl group or the hetero aryl group can consist of one to four aromatic and/or hetero aromatic rings. When the number of the aromatic and/or hetero aromatic rings of R¹ to R⁴ becomes more than four, conjugated structure within the whole molecule becomes too long, thus, the organometallic compound can have too narrow energy bandgap. For example, each of the aryl group or the hetero aryl group of R¹ to R⁴ can comprise independently, but is not limited to, phenyl, biphenyl, naphthyl, anthracenyl, pyrrolyl, triazinyl, imidazolyl, pyrazolyl, pyridinyl, pyrazinyl, pyrimidinyl, pyridazinyl, furanyl, benzo-furanyl, dibenzo-furanyl, thiophenyl, benzo-thiophenyl, dibenzo-thiophenyl, carbazolyl, acridinyl, carbolinyl, phenazinyl, phenoxazinyl, or phenothiazinyl.

Each of the C₆-C₃₀ aryl group and/or the C₃-C₃₀ hetero aryl group of R¹ to R⁴ in Chemical Formula 1 can be independently unsubstituted or substituted with at least one group selected from a C₁-C₁₀ alkyl group, a C₆-C₂₀ aryl group and a C₃-C₂₀ hetero aryl group. For example, each of R¹ and R² in Chemical Formula 1 can be independently a C₆-C₂₀ aryl group such as naphthyl (*e.g*., 1-napthyl or 2-naphthyl) and phenanthrenyl, each of R³ and R⁴ can be independently hydrogen or a C₁-C₁₀ alkyl group (*e.g*., methyl or tert-butyl) and each of L¹ and L² can be independently a single bond or a C₆-C₂₀ arylene group (*e.g*., phenylene), but is not limited thereto.

A first host 342 having the structure of Chemical Formula 1 can include, but is not limited to, 9,10-di(naphthalen-2-yl)anthracene (ADN), 2-methyl-9,10-bis(naphthalen-2-yl)anthracene (MADN), 2-tert-Butyl-9,10-di(naphthen-2-yl)anthracene (TBADN), 9,10-di(naphthalen-2-yl)-2-phenylanthracene (PADN), 9,10-di(1-naphthyl)anthracene, 9-(naphthalene-1-yl)-10-(naphthalene-2-yl)anthracene, 9-(2-napthyl)-10-[4-(1-naphthyl)phenyl]anthracene, 9-(1-napthyl)-10-[4-(2-naphthyl)phenyl]anthracene, 9-phenyl-10-(p-tolyl)anthracene (PTA), 9-(1-naphthyl)-10-(p-tolyl)anthracene (1-NTA), 9-(2-naphthyl)-10-(p-tolyl)anthracene (2-NTA), 2-[4-(9,10-Di-naphthalen-2-yl-anthracen-2-yl)-phenyl]-1-phenyl-1H-benzimidazole (ZADN) and/or combinations thereof.

According to the invention, the first host 342 is at least one of the organic compounds BH1-2 to BH1-8 as disclosed above.

In one embodiment, the first host 342 can have HOMO energy level between about -5.9 eV and about -6.1 eV, for example, less than about -5.9 eV and about -6.1 eV, and can have an excited triplet energy level between about 1.7 eV and 1.9 eV, but is not limited thereto.

The second host 344 is an organic compound where a dibenzofuran group is directly linked to an anthracene core. Generally, a second host 344 can be an anthracene-based organic compound having the following structure of Chemical Formula 3: 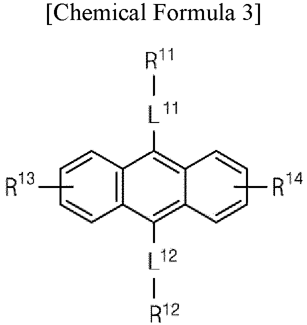 wherein, in the Chemical Formula 3,
each of R¹¹ and R¹² is independently an unsubstituted or substituted C₆-C₃₀ aryl group or an unsubstituted or substituted C₃-C₃₀ hetero aryl group, where at least one of R¹¹ and R¹² is the unsubstituted or substituted C₃-C₃₀ hetero aryl group;
each of R¹³ and R¹⁴ is independently hydrogen, an unsubstituted or substituted C₁-C₂₀ alkyl group, an unsubstituted or substituted C₆-C₃₀ aryl group or an unsubstituted or substituted C₃-C₃₀ hetero aryl group; and
each of L¹¹ and L¹² is independently a single bond, an unsubstituted or substituted C₆-C₃₀ arylene group or an unsubstituted or substituted C₃-C₃₀ hetero arylene group.

Each of the C₆-C₃₀ aryl group and/or the C₃-C₃₀ hetero aryl group of R¹¹ to R¹⁴ in Chemical Formula 3 can be independently unsubstituted or substituted with at least one group selected from a C₁-C₁₀ alkyl group, a C₆-C₂₀ aryl group and a C₃-C₂₀ hetero aryl group. For example, one of R¹¹ and R² in Chemical Formula 3 can be a C₆-C₂₀ aryl group such as naphthyl (*e.g*., 1-napthyl or 2-naphthyl) and the other of R¹¹ and R² can be a C₈-C₂₀ hetero aryl group such as dibenzofuranyl and/or dibenzothiophenyl, each of R¹³ and R¹⁴ can be independently hydrogen or a C₁-C₁₀ alkyl group (*e.g*., methyl or tert-butyl) and each of L¹¹ and L¹² can be independently a single bond or a C₆-C₂₀ arylene group (*e.g*., phenylene), but is not limited thereto.

A second host 344 having the structure of Chemical Formula 3 can include, but is not limited to, 2-(3-(10-phenylanthracen-9-yl)-phenyl)dibenzo[b,d]furan (m-PPDF), 2-(4-(10-phenylanthracen-9-yl)phenyl)dibenzo[b,d]furan (p-PPDF) and/or combinations thereof.

According to the invention, the second host 344 is at least one of the organic compounds BH2-2 to BH2-7 as disclosed above.

In one embodiment, the second host 344 can have HOMO energy level between about -5.8 eV and -5.9 eV and excited triplet energy level between about 1.7 eV and about 1.9 eV, but is not limited thereto.

The blue emitter 346 can include at least one of blue phosphorescent material, blue fluorescent material and blue delayed fluorescent material. For example, the blue emitter 346 can include, but is not limited to, perylene, 4,4'-Bis[4-(di-p-tolylamino)styryl]biphenyl (DPAVBi), 4-(Di-p-tolylamino)-4-4'-[(di-p-tolylamino)styryl]stilbene (DPAVB), 4,4'-Bis[4-(diphenylamino)styryl]biphenyl (BDAVBi), 2,7-Bis(4-diphenylamino)styryl)-9,9-spirofluorene (spiro-DPVBi), [1,4-bis[2-[4-[N,N-di(p-tolyl)amino]phenyl]vinyl]benzene (DSB), 1-4-di-[4-(N,N-diphenyl)amino]styryl-benzene (DSA), 2,5,8,11-Tetra-tetr-butylperylene (TBPe), Bis((2-hydroxylphenyl)-pyridine)beryllium (Bepp₂), 9-(9-Phenylcarbazol-3-yl)-10-(naphthalen-1-yl)anthracene (PCAN), mer-Tris(1-phenyl-3-methylimidazolin-2-ylidene-C,C(2))'iridium(III) (mer-Ir(pmi)₃), fac-Tris(1,3-diphenyl-benzimidazolin-2-ylidene-C,C(2))'iridium(III) (fac-Ir(dpbic)₃), Bis(3,4,5-trifluoro-2-(2-pyridyl)phenyl-(2-carboxypyridyl))iridium(III) (Ir(tfpd)₂pic), tris(2-(4,6-difluorophenyl)pyridine)iridium(III) (Ir(Fppy)₃), Bis[2-(4,6-difluorophenyl)pyridinato-C²,N](picolinato)iridium(III) (FIrpic), DABNA-1, DABNA-2, t-DABNA, v-DABNA and/or combinations thereof.

The first host 342 and the second host 344 in the EML 340 are admixed with a weight ratio between about 9:1 to about 7:3, for example, about 9:1 to about 8:2. The contents of the host including the first host 342 and the second host 344 in the EML 340 can be about 50 wt% to about 99 wt%, for example, about 80 wt% to about 95 wt%, and the contents of the blue emitter 346 in the EML 340 can be about 1 wt% to about 50 wt%, for example, about 5 wt% to about 20 wt%, but is not limited thereto.

The EML 340 includes the first host 342 and the second host 344 in order to inject holes efficiently to the EML 340.

FIG. 4 illustrates a schematic diagram showing energy levels among a common layer and a blue emitting material layer in a conventional organic light emitting diode with a single emitting unit. As described below, the HIL 310 disposed adjacently to the first electrode 210 can include inorganic material such as MgF₂ as a P-type dopant in order to improve adhesion and interfacial property between the first electrode 210 of inorganic material and the HTL of organic material. Hole injection property can be changed by interactions and HOMO energy level among the HIL 310, which can include the inorganic material, the HTL 320 and the EBL 330 (or HTL2). For example, hole transporting material in the HTL 320 can have HOMO energy level between about -5.5 eV and about -5.7 eV and electron blocking material in the EBL 330 can have HOMO energy level between about -5.7 eV and about -5.8 eV. On the contrary, the host in the conventional blue emitting material layer 340 can have HOMO energy level around -6.0 eV.

The energy bandgap ΔHOMO1 between the HOMO energy level of the host in the conventional blue emitting material layer EML and the HOMO energy level of the hole transporting material and/or the electron blocking material in the HTL 320 and/or the EBL 330 is 0.2 eV or more. Since the HOMO energy bandgap ΔHOMO 1 between the blue emitting material layer EML using a single host and the HTL 320 and/or the EBL 330 disposed adjacently to the blue emitting material layer EML is relatively large, the holes generated in the first electrode 210 cannot be injected efficiently into the blue emitting material layer EML. A portion of the generated holes is accumulated in an interface between the blue emitting material layer 340, and the HTL 320 and/or the EBL 330.

The holes accumulated in the interface between the blue emitting material layer EML, and the HTL 320 and/or the EBL 330 cannot be recombined with electrons and quenched as non-emission. The luminous efficiency of an organic light emitting diode can be lowered as sufficient excitons are not generated in the conventional blue emitting material layer EML. In addition, the driving voltage of the organic light emitting diode can be raised as holes not injected into the conventional blue emitting material layer EML are quenched as non-emission.

In addition, the holes accumulated in the interface between the conventional blue emitting material layer EML, and the HTL 320 and/or the EBL 330 disposed adjacently to the blue emitting material layer EML can act as stress to the hole transporting material in the HTL 320 and/or the electron blocking material in the EBL 330. The accumulated holes can cause the hole transporting material and/or the electron blocking material to be deteriorated, and thus, the luminous lifespan of the organic light emitting diode can be reduced.

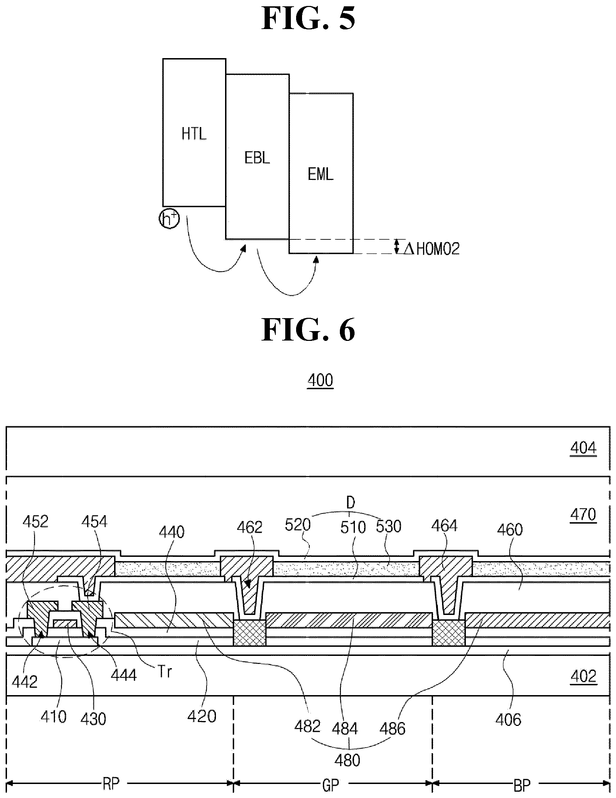

FIG. 5 illustrates a schematic diagram showing energy levels among a common layer and a blue emitting material layer in an organic light emitting diode with a single emitting unit in accordance with an embodiment of the present invention.

As illustrated in FIGS. 3 and 5, the blue emitting material layer 340 (EML) in the OLED D1 can include the first host 342 and the second host 344. The first host 342 has a HOMO energy level between about -5.9 eV and about -6.1 eV and the second host 344 has a HOMO energy level between about -5.8 eV and about -5.9 eV.

The energy bandgap ΔHOMO2 between the HOMO energy level of the host in the blue EML 340 including the first and second hosts 342 and 344, and the HOMO energy level of the hole transporting material in the HTL and/or the electron blocking material in the EBL 330 can be reduced significantly compared to the energy bandgap ΔHOMO1 between the HOMO energy level of the host in the conventional blue emitting material layer using the single host, and the HOMO energy level of the hole transporting material and/or the electron blocking material. In one embodiment, the energy bandgap ΔHOMO2 between the HOMO energy level of the host in the blue EML 340 including both the first and second hosts 342 and 344, and the HOMO energy level of the hole transporting material and/or the electron blocking material can be about 0.15 eV or less, for example, about 0.1 eV or less.

The holes generated at the first electrode 210 can be injected rapidly into the blue EML 340 via the HTL 320 and the EBL 330. Since the holes injected efficiently into the blue EML 340 can be recombined with electrons to generate effective excitons, the luminous efficiency of the OLED D1 can be improved.

In addition, it is possible to minimize the amount of non-emitting excitons as the excitons are quenched outside of the EML 340. In this case, excitons are not quenched as non-emissive by triplet-triplet annihilation (TTA) and/or triplet-polaron annihilation (TPA). As the exciton quenching in the interface between the EML 340, and the HTL 320 and/or the EBL 330 disposed adjacently to the EML 340 becomes minimal, it is possible to prevent the driving voltage of the OLED D1 from being raised.

Also, it is possible to minimize the amount of hole accumulations in the interface between the blue EML 340, and the HTL 320 and/or the EBL 330 disposed adjacently to the EML 340. As the hole transporting material and/or the electron blocking material are not deteriorated owing to the accumulated holes, the luminous lifespan of the OLED D1 can be improved.

Returning to FIG. 3, the HIL 310 is disposed between the first electrode 210 and the HTL 320 and can improve an interface property between the inorganic first electrode 210 and the organic HTL 320. In one embodiment, the HIL 310 can include, but is not limited to, 4,4',4"-Tris(3-methylphenylamino)triphenylamine (MTDATA), 4,4',4"-Tris(N,N-diphenyl-amino)triphenylamine (NATA), 4,4',4"-Tris(N-(naphthalene-1-yl)-N-phenyl-amino)triphenylamine (1T-NATA), 4,4',4"-Tris(N-(naphthalene-2-yl)-N-phenyl-amino)triphenylamine (2T-NATA), Copper phthalocyanine (CuPc), Tris(4-carbazoyl-9-yl-phenyl)amine (TCTA), N,N'-Diphenyl-N,N'-bis(1-naphthyl)-1,1'-biphenyl-4,4"-diamine (NPB; NPD), N,N'-Bis{4-[bis(3-methylphenyl)amino]phenyl}-N,N'-diphenyl-4,4'-biphenyldiamine (DNTPD), 1,4,5,8,9,11-Hexaazatriphenylenehexacarbonitrile (Dipyrazino[2,3-f:2'3'-h]quinoxaline-2,3,6,7,10,11-hexacarbonitrile; HAT-CN), 2,3,5,6-Tetrafluoro-7,7,8,8-tetracyanoquinodimethane (F4-TCNQ), 1,3,4,5,7,8-hexafluoro-tetracyano-naphthoquinodimethane (F6-TCNNQ), 1,3,5-tris[4-(diphenylamino)phenyl]benzene (TDAPB), poly(3,4-ethylenedioxythiphene)polystyrene sulfonate (PEDOT/PSS), N-(biphenyl-4-yl)-9,9-dimethyl-N-(4-(9-phenyl-9H-carbazol-3-yl)phenyl)-9H-fluoren-2-amine, N,N'-diphenyl-N,N'-di[4-(N,N'-diphenyl-amino)phenyl]benzidine (NPNPB), Di-[4-(N,N-di-p-toylyl-amino)-phenyl]cyclohexane (TAPC), N4,N4,N4',N4'-Tetra[(1,1'-biphenyl)-4-yl]-(1,1'-biphenyl)-4,4'-diamine (BPBPA), MgF₂, CaF₂ and/or combinations thereof.

In an alternative embodiment, the HIL 310 can include the hole transporting material described below doped with the above hole injecting material (e.g., organic material such as HAT-CN, F4-TCNA and/or F6-TCNNQ and/or inorganic material such as MgF₂ and/or CaF₂). In this case, the contents of the hole injecting material in the HIL 310 can be, but is not limited to, about 1 wt% to about 50 wt%, for example, about 5 wt% to about 50 wt%. In certain embodiments, the HIL 310 can be omitted in compliance of the OLED D1 property.

The HTL 320 is disposed between the first electrode 210 and the EML 340. In one embodiment, the HTL 320 can include, but is not limited to, N,N'-Diphenyl-N,N'-bis(3-methylphenyl)-1,1'-biphenyl-4,4'-diamine (TPD), NPB(NPD), 4,4'-bis(N-carbazolyl)-1,1'-biphenyl (CBP), DNTPD, BPBPA, NPNPB, Poly[N,N'-bis(4-butylphenyl)-N,N'-bis(phenyl)-benzidine] (Poly-TPD), Poly[(9,9-dioctylfluorenyl-2,7-diyl)-co-(4,4'-(N-(4-sec-butylphenyl)diphenylamine))] (TFB), TAPC, 3,5-Di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl-4-amine, N-([1,1'-Biphenyl]-4-yl)-9,9-dimethyl-N-(4-(9-phenyl-9H-carbazol-3-yl)phenyl)-9H-fluoren-2-amine and/or combinations thereof.

The ETL 360 and the EIL 370 can be laminated sequentially between the EML 340 and the second electrode 220. An electron transporting material included in the ETL 360 has high electron moibity so as to provide electrons stably with the EML 340 by fast electron transportation.

In one embodiment, the ETL 360 can include at least one of an oxadiazole-based compound, a triazole-based compound, a phenanthroline-based compound, a benzoxazole-based compound, a benzothiazole-based compound, a benzimidazole-based compound, and a triazine-based compound.

For example, the ETL 360 can include, but is not limited to, tris-(8-hydroxyquinoline) aluminum (Alq₃), 2-biphenyl-4-yl-5-(4-t-butylphenyl)-1,3,4-oxadiazole (PBD), spiro-PBD, lithium quinolate (Liq), 2,2', 2"-(1,3,5-benzenetriyl)-tris(1-phenyl-1-H-benzimidazole) (TPBi), Bis(2-methyl-8-quinolinolato-N1,O8)-(1,1'-biphenyl-4-olato)aluminum (BAlq), 4,7-diphenyl-1,10-phenanthroline (Bphen), 2,9-Bis(naphthalene-2-yl)4,7-diphenyl-1,10-phenanthroline (NBphen), 2,9-Dimethyl-4,7-diphenyl-1,10-phenathroline (BCP), 3-(4-Biphenyl)-4-phenyl-5-tert-butylphenyl-1,2,4-triazole (TAZ), 4-(Naphthalen-1-yl)-3,5-diphenyl-4H-1,2,4-triazole (NTAZ), 1,3,5-Tri(p-pyrid-3-yl-phenyl)benzene (TpPyPB), 2,4,6-Tris(3'-(pyridin-3-yl)biphenyl-3-yl)1,3,5-triazine (TmPPPyTz), Poly[9,9-bis(3'-((N,N-dimethyl)-N-ethylammonium)-propyl)-2,7-fluorene]-alt-2,7-(9,9-dioctylfluorene)] dibromide (PFNBr), tris(phenylquinoxaline) (TPQ), TSPO1, 2-[4-(9,10-Di-2-naphthalen2-yl-2-anthracen-2-yl)phenyl]-1-phenyl-1H-benzimidazole (ZADN) and/or combinations thereof.

The EIL 370 is disposed between the second electrode 220 and the ETL 360, and can improve physical properties of the second electrode 220 and therefore, can enhance the lifespan of the OLED D1. In one embodiment, the EIL 370 can include, but is not limited to, an alkali metal halide and/or an alkaline earth metal halide such as LiF, CsF, NaF, BaF₂ and the like, and/or an organometallic compound such as Liq, lithium benzoate, sodium stearate, and the like.

In an alternative embodiment, the ETL 360 and the EIL 370 can have a single layered structure. In this case, the above electron transporting material and/or the electron injecting material can be admixed with each other. As an example, the ETL/EIL can include two or more different electron transporting materials. For example, two electron transporting materials in the ETL/EIL are admixed with, but is not limited to, a weight ratio of about 3:7 to about 7:3.

When holes are transferred to the second electrode 220 via the EML 340, the OLED D1 can have short lifespan and reduced luminous efficiency. In order to prevent those phenomena, the OLED D1 in accordance with this aspect of the present invention can further include at least one exciton blocking layer disposed adjacently to the EML 340. For example, the OLED D1 in accordance with this aspect of the present invention can further include the EBL 330 between the HTL 320 and the EML 340 so as to control and prevent electron transportation. As an example, the EBL 330 can include, but is not limited to, TCTA, N-(biphenyl-4-yl)-9,9-dimethyl-N-(4-(9-phenyl-9H-carbazol-3-yl)phenyl)-9H-fluoren-2-amine, TAPC, MTDATA, 1,3-Bis(carbazol-9-yl)benzene (mCP), 3,3-Di(9H-carbazol-9-yl)biphenyl (mCBP), CuPc, DNTPD, TDABP, DCDPA, 2,8-bis(9-phenyl-9H-carbazol-3-yl)dibenzo[b,d]thiophene and/or combinations thereof.

In addition, the OLED D1 in accordance with this aspect of the present invention can further include the HBL 350 between the EML 340 and the ETL 360 so that holes cannot be transferred from the EML 340 to the ETL 360. In one embodiment, the HBL 350 can include, but is not limited to, at least one of an oxadiazole-based compound, a triazole-based compound, a phenanthroline-based compound, a benzoxazole-based compound, a benzothiazole-based compound, a benzimidazole-based compound, and a triazine-based compound.

For example, the HBL 350 can include material having a relatively low HOMO energy level compared to the luminescent materials in EML 340. The HBL 350 can include, but is not limited to, BCP, BAlq, Alq₃, PBD, spiro-PBD, Liq, Bis-4,5-(3,5-di-3-pyridylphenyl)-2-methylpyrimidine (B3PYMPM), DPEPO, 9-(6-(9H-carbazol-9-yl)pyridine-3-yl)-9H-3,9'-bicarbazole, TSPO1 and/or combinations thereof. In certain embodiments, each of the EBL 330 and/or the HBL 350 can be omitted.

An organic light emitting display device and an organic light emitting diode with a single emitting unit emitting blue color light is described in the above embodiment. In another embodiment, an organic light emitting display device can implement full-color including white color. As an example, FIG. 6 illustrates a schematic cross-sectional view of an organic light emitting display device in accordance with another embodiment of the present invention.

As illustrated in FIG. 6, an organic light emitting display device 400 comprises a first substrate 402 that defines each of a red pixel region RP, a green pixel region GP and a blue pixel region BP, a second substrate 404 facing the first substrate 402, a thin film transistor Tr on the first substrate 402, an organic light emitting diode (OLED) D disposed between the first and second substrates 402 and 404 and emitting white (W) light and a color filter layer 480 disposed between the OLED D and the first substrate 402. The organic light emitting display device 400 can include a plurality of such pixel regions arranged in a matrix configuration or other suitable configurations.

Each of the first and second substrates 402 and 404 can include, but is not limited to, glass, flexible material and/or polymer plastics. For example, each of the first and second substrates 402 and 404 can be made of PI, PES, PEN, PET, PC and/or combinations thereof. The first substrate 402, on which a thin film transistor Tr and the OLED D are arranged, forms an array substrate.

A buffer layer 406 can be disposed on the first substrate 402. The thin film transistor Tr is disposed on the buffer layer 406 correspondingly to each of the red pixel region RP, the green pixel region GP and the blue pixel region BP. In certain embodiments, the buffer layer 406 can be omitted.

A semiconductor layer 410 is disposed on the buffer layer 406. The semiconductor layer 410 can be made of or include oxide semiconductor material or polycrystalline silicon.

A gate insulating layer 420 including an insulating material, for example, inorganic insulating material such as silicon oxide (SiOₓ, wherein 0 < x ≤ 2) or silicon nitride (SiNₓ, wherein 0 < x ≤ 2) is disposed on the semiconductor layer 410.

A gate electrode 430 made of a conductive material such as a metal is disposed over the gate insulating layer 420 so as to correspond to a center or middle area of the semiconductor layer 410. An interlayer insulating layer 440 including an insulating material, for example, inorganic insulating material such as SiOₓ or SiNₓ, or an organic insulating material such as benzocyclobutene or photo-acryl, is disposed on the gate electrode 430.

The interlayer insulating layer 440 has first and second semiconductor layer contact holes 442 and 444 that expose or do not cover a portion of the surface nearer to the opposing ends than to a center of the semiconductor layer 410. The first and second semiconductor layer contact holes 442 and 444 are disposed on opposite sides of the gate electrode 430 with spacing apart from the gate electrode 430.

A source electrode 452 and a drain electrode 454, which are made of or include a conductive material such as a metal, are disposed on the interlayer insulating layer 440. The source electrode 452 and the drain electrode 454 are spaced apart from each other with respect to the gate electrode 430. The source electrode 452 and the drain electrode 454 contact both sides of the semiconductor layer 410 through the first and second semiconductor layer contact holes 442 and 444, respectively. The source and drain electrodes 452 and 454 can be switched with each other depending on the types of transistors and display structure used.

The semiconductor layer 410, the gate electrode 430, the source electrode 452 and the drain electrode 454 constitute the thin film transistor Tr, which acts as a driving element.

In some aspects, as shown in FIG. 1, the gate line GL and the data line DL, which cross each other to define the pixel region P, and a switching element Ts, which is connected to the gate line GL and the data line DL, can be further formed in the pixel region P. The switching element Ts is connected to the thin film transistor Tr, which is a driving element. In addition, the power line PL is spaced apart in parallel from the gate line GL or the data line DL, and the thin film transistor Tr can further include the storage capacitor Cst configured to constantly keep a voltage of the gate electrode 430 for one frame.

A passivation layer 460 is disposed on the source electrode 452 and the drain electrode 454 and covers the thin film transistor Tr over the whole first substrate 402. The passivation layer 460 has a drain contact hole 462 that exposes or does not cover the drain electrode 454 of the thin film transistor Tr.

The OLED D is located on the passivation layer 460. The OLED D includes a first electrode 510 that is connected to the drain electrode 454 of the thin film transistor Tr, a second electrode 520 facing the first electrode 510 and an emissive layer 530 disposed between the first and second electrodes 510 and 520.

The first electrode 510 formed for each pixel region RP, GP or BP can be an anode and can include a conductive material having relatively high work function value. For example, the first electrode 510 can include, but is not limited to, ITO, IZO, ITZO, SnO, ZnO, ICO, AZO, and/or combinations thereof.

A bank layer 464 is disposed on the passivation layer 460 in order to cover edges of the first electrode 510. The bank layer 464 exposes or does not cover a center of the first electrode 510 corresponding to each of the red pixel region RP, the green pixel region GP and the blue pixel region BP. In certain embodiments, the bank layer 464 can be omitted.

An emissive layer 530 that can include multiple emitting parts is disposed on the first electrode 510. As illustrated in FIG. 7 as one example, the emissive layer 530 can include multiple emitting parts 600, 700 and 800, and at least one charge generation layer 680 and 780. Each of the emitting parts 600, 700 and 800 includes at least one emitting material layer and can further include an HIL, an HTL, an EBL, an HBL, an ETL and/or an EIL. FIG. 7 will be discussed in more detail later.

Referring back to FIG. 6, the second electrode 520 can be disposed on the first substrate 402 above which the emissive layer 530 can be disposed. The second electrode 520 can be disposed over a whole display area, can include a conductive material with a relatively low work function value compared to the first electrode 510, and can be a cathode. For example, the second electrode 520 can include, but is not limited to, highly reflective material such as Al, Mg, Ca, Ag, alloy thereof, and/or combinations thereof such as Al-Mg.

The color filter layer 480 is disposed between the first substrate 402 and the OLED D, for example, the interlayer insulating layer 440 and the passivation layer 460. The color filter layer 480 can include a red color filter pattern 482, a green color filter pattern 484 and a blue color filter pattern 486 each of which is disposed correspondingly to the red pixel region RP, the green pixel region GP and the blue pixel region BP, respectively.

In addition, an encapsulation film 470 can be disposed on the second electrode 520 in order to prevent or reduce outer moisture from penetrating into the OLED D. The encapsulation film 470 can have, but is not limited to, a laminated structure including a first inorganic insulating film, an organic insulating film and a second inorganic insulating film (e.g., film 170 in FIG. 2). In addition, a polarizing plate can be attached onto the second substrate 404 to reduce reflection of external light. For example, the polarizing plate can be a circular polarizing plate.

In FIG. 6, the light emitted from the OLED D is transmitted through the first electrode 510 and the color filter layer 480 is disposed under the OLED D. The organic light emitting display device 400 can be a bottom-emission type. Alternatively, the light emitted from the OLED D is transmitted through the second electrode 520 and the color filter layer 480 can be disposed on the OLED D when the organic light emitting display device 400 is a top-emission type. In this case, the color filter layer 480 can be attached to the OLED D by adhesive layer. Alternatively, the color filter layer 480 can be disposed directly on the OLED D.

In addition, a color conversion layer can be formed or disposed between the OLED D and the color filter layer 480. The color conversion layer can include a red color conversion layer, a green color conversion layer and a blue color conversion layer each of which is disposed correspondingly to each pixel region (RP, GP and BP), respectively, so as to convert the white (W) color light to each of a red, green and blue color lights, respectively. For example, the color conversion layer can include quantum dots so that the color purity of the organic light emitting display device 400 can be further improved. Alternatively, the organic light emitting display device 400 can comprise the color conversion layer instead of the color filter layer 480.

As described above, the white (W) color light emitted from the OLED D is transmitted through the red color filter pattern 482, the green color filter pattern 484 and the blue color filter pattern 486 each of which is disposed correspondingly to the red pixel region RP, the green pixel region GP and the blue pixel region BP, respectively, so that red, green and blue color lights are displayed in the red pixel region RP, the green pixel region GP and the blue pixel region BP.

An OLED that can be applied into the organic light emitting display device will now be described in more detail. An example of the OLED D of FIG. 6 is shown in FIG. 7 as an OLED D2. Particularly, FIG. 7 illustrates a schematic cross-sectional view of an organic light emitting diode having a tandem structure of three emitting parts.

As illustrated in FIG. 7, the OLED D2 in accordance with the embodiment of the present invention includes first and second electrodes 510 and 520 and an emissive layer 530 disposed between the first and second electrodes 510 and 520. The emissive layer 530 includes a first emitting part 600 disposed between the first and second electrodes 510 and 520, a second emitting part 700 disposed between the first emitting part 600 and the second electrode 520, a third emitting part 800 disposed between the second emitting part 700 and the second electrode 520, a first charge generation layer (CGL1) 680 disposed between the first and second emitting parts 600 and 700, and a second charge generation layer (CGL2) 780 disposed between the second and third emitting parts 700 and 800.

The first electrode 510 can be an anode and can include a conductive material having relatively high work function value such as TCO. The second electrode 520 can be a cathode and can include a conductive material with a relatively low work function value, for example, highly reflective material.

The first emitting part 600 includes a first emitting material layer (EML1) 640. The first emitting part 600 can include at least one of a hole injection layer (HIL) 610 disposed between the first electrode 510 and the EML1 640, a first hole transport layer (HTL1) 620 disposed between the HIL 610 and the EML1 640, and a first electron transport layer (ETL1) 660 disposed between the EML1 640 and the CGL1 680. Alternatively, the first emitting part 600 can further include a first electron blocking layer (EBL1) 630 disposed between the HTL1 620 and the EML1 640 and/or a first hole blocking layer (HBL1) 650 disposed between the EML1 640 and the ETL1 660.

The second emitting part 700 includes a second emitting material layer (EML2) 740. The second emitting part 700 can include at least one of a second hole transport layer (HTL2) 720 disposed between the CGL1 680 and the EML2 740 and a second electron transport layer (ETL2) 760 disposed between the EML2 740 and the CGL2 780. Alternatively, the second emitting part 700 can further include at least one of a second electron blocking layer 730 (EBL2) disposed between the HTL2 720 and the EML2 740 and a second hole blocking layer (HBL2) 750 disposed between the EML2 740 and the ETL2 760.

The third emitting part 800 includes a third emitting material layer (EML3) 840. The third emitting part 800 can include at least one of a third hole transport layer (HTL3) 820 disposed between the CGL2 780 and the EML3 840, a third electron transport layer (ETL3) 860 disposed between the EML3 840 and the second electrode 520, and an electron injection layer (EIL) 870 disposed between the ETL3 860 and the second electrode 520. Alternatively, the third emitting part 800 can further include at least one of a third electron blocking layer (EBL3) 830 disposed between the HTL3 820 and the EML3 840 and a third hole blocking layer (HBL3) 850 disposed between the EML3 840 and the ETL3 860.

The HIL 610 is disposed between the first electrode 510 and the HTL1 620 and improves an interface property between the inorganic first electrode 510 and the organic HTL1 620. In one embodiment, the HIL 610 can include, but is not limited to, MTDATA, NATA, 1T-NATA, 2T-NATA, CuPc, TCTA, NPB (NPD), DNTPD, HAT-CN, F4-TCNA, F6-TCNNQ, TDAPB, PEDOT/PSS, N-(biphenyl-4-yl)-9,9-dimethyl-N-(4-(9-phenyl-9H-carbazol-3-yl)phenyl)-9H-fluoren-2-amine, NPNPB, TAPC, BPBPA, MgF₂, CaF₂ and/or combinations thereof. Alternatively, the HIL 610 can include the hole transporting material doped with the hole injecting material. In certain embodiments, the HIL 610 can be omitted in compliance of the OLED D2 property.

The HTL1 620, the HTL2 720 and the HTL3 820 can facilitate the hole transportation in the first emitting part 600, the second emitting part 700 and the third emitting part 800, respectively. In one embodiment, each of the HTL1 620, the HTL2 720 and the HTL3 820 can include, but is not limited to, TPD, NPB (NPD), CBP, DNTPD, BPBPA, NPNPB, Poly-TPD, TFB, TAPC, DCDPA, N-(biphenyl-4-yl)-9,9-dimethyl-N-(4-(9-phenyl-9H-carbazol-3-yl)phenyl)-9H-fluoren-2-amine, N-(biphenyl-4-yl)-N-(4-(9-phenyl-9H-carbazol-3-yl)phenyl)biphenyl-4-amine, N-([1,1'-Biphenyl]-4-yl)-9,9-dimethyl-N-(4-(9-phenyl-9H-carbazol-3-yl)phenyl)-9H-fluoren-2-amine and/or combination thereof.

The ETL1 660, the ETL2 760 and the ETL3 860 can facilitate electron transportation in the first emitting part 600, the second emitting part 700 and the third emitting part 800, respectively. As an example, each of the ETL1 660, the ETL2 760 and the ETL3 860 can include at least one of an oxadiazole-based compound, a triazole-based compound, a phenanthroline-based compound, a benzoxazole-based compound, a benzothiazole-based compound, a benzimidazole-based compound and a triazine-based compound. For example, each of the ETL1 660, the ETL2 760 and the ETL3 860 can include, but is not limited to, Alq₃, PBD, spiro-PBD, Liq, TPBi, BAlq, Bphen, NBphen, BCP, TAZ, NTAZ, TpPyPB, TmPPPyTz, PFNBr, TPQ, TSPO1, ZADN and/or combinations thereof.

The EIL 870 is disposed between the second electrode 520 and the ETL3 860, and can improve physical properties of the second electrode 520 and therefore, can enhance the lifespan of the OLED D2. In one embodiment, the EIL 870 can include, but is not limited to, an alkali metal halide or an alkaline earth metal halide such as LiF, CsF, NaF, BaF₂ and the like, and/or an organometallic Compound such as Liq, lithium benzoate, sodium stearate, and the like.

Each of the EBL1 630, the EBL2 730 and the EBL3 830 can independently include, but is not limited to, TCTA, Tris[4-(diethylamino)phenyl]amine, N-(biphenyl-4-yl)-9,9-dimethyl-N-(4-(9-phenyl-9H-carbazol-3-yl)phenyl)-9H-fluorene-2-amine, TAPC, MTDATA, mCP, mCBP, CuPc, DNTPD, TDAPB, DCDPA, 2,8-bis(9-phenyl-9H-carbazol-3-yl)dibenzo[b,d]thiophene and/or combinations thereof, respectively.

Each of the HBL1 650, the HBL2 750 and the HBL3 850 can include, but is not limited to, at least one of an oxadiazole-based compound, a triazole-based compound, a phenanthroline-based compound, a benzoxazole-based compound, a benzothiazole-based compound, a benzimidazole-based compound, and a triazine-based compound. For example, each of the HBL1 650, the HBL2 750 and the HBL3 850 can independently include, but is not limited to, BCP, BAlq, Alq₃, PBD, spiro-PBD, Liq, B3PYMPM, DPEPO, 9-(6-(9H-carbazol-9-yl)pyridine-3-yl)-9H-3,9'-bicarbazole, TSPO1 and/or combinations thereof, respectively.

The CGL1 680 is disposed between the first emitting part 600 and the second emitting part 700. The CGL1 680 includes a first N-type CGL (N-CGL1) 682 disposed between the ETL1 660 and the HTL2 720 and a first P-type CGL (P-CGL1) 684 disposed between the N-CGL1 682 and the HTL 720. The CGL2 780 is disposed between the second emitting part 700 and the third emitting part 800. The CGL2 780 includes a second N-type CGL (N-CGL2) 782 disposed between the ETL2 760 and the HTL3 820 and a second P-type CGL (P-CGL2) 784 disposed between the N-CGL2 782 and the HTL3 820.

Each of the N-CGL1 682 and the N-CGL2 782 provides electrons to the EML1 640 of the first emitting part 600 and the EML2 740 of the second emitting part 700, respectively. Each of the P-CGL1 684 and the P-CGL2 784 provides holes to the EML2 740 of the second emitting part 700 and the EML3 840 of the third emitting part 800, respectively.

Each of the N-CGL1 682 and the N-CGL2 782 can be an organic layer with electron transporting material doped with an alkali metal such as Li, Na, K and Cs and/or an alkaline earth metal such as Mg, Sr, Ba and Ra. For example, the contents of the alkali metal and/or the alkaline earth metal in each of the N-CGL1 682 and the N-CGL2 782 can be, but is not limited to, between about 0.1 wt% and about 30 wt%, for example, about 1 wt% and about 10 wt%.

In one embodiment, each of the P-CGL1 684 and the P-CGL2 784 can include, but is not limited to, inorganic material selected from the group consisting of WOₓ, MoOₓ, Be₂O₃, V₂O₅ and/or combinations thereof. In another embodiment, each of the P-CGL1 684 and the P-CGL2 784 can include organic material of the hole transporting material doped with the hole injecting material (e.g., organic material such as HAT-CN, F4-TCNQ and/or F6-TCNNQ and/or inorganic material such as MgF₂ and/or CaF₂). In this case, the contents of the hole injecting material in the P-CGL1 684 and the P-CGL2 784 can be, but is not limited to, between about 2 wt% and about 15 wt%.

In one embodiment, two of the EML1 640, the EML2 740 and the EML3 840 can emit blue color light and the other of the EML1 640, the EML2 740 and the EML3 840 can emit red to green color light, so that the OLED D2 can realize white (W) emission. Hereinafter, the OLED D2 where the EML1 640 and the EML3 840 emit blue color light and the EML2 740 emits red to green color light will be described in more detail.

The EML1 (first blue EML) 640 can include a first host 642, a second host 644 and a blue emitter 646. The EML3 (second blue EML) 840 can include a first host 842, a second host 844 and a blue emitter 846. Each of the first hosts 642 and 842 can be independently the anthracene-based organic compound having the structure of Chemical Formulae 1 to 2, and each of the second hosts 644 and 844 can be independently the anthracene-based organic compound having the structure of Chemical Formulae 3 to 4. The HOMO energy level, excited triplet energy level of the first hosts 642 and 842 and the second hosts 644 and 844, and the contents of those hosts in each of the EML1 640 and the EML3 840 can be correspondingly identical to those with referring to FIGS. 3 and 5.

In this case, each of the EML1 640 and the EML3 840 can be a blue EML, a sky-blue EML or a deep-blue EML.

The hosts 642 and 644 in the EML1 640 can be identical to or different form the hosts 842 and 844 in the EML3 840. In addition, the blue emitter 646 in the EML1 640 can be identical to or different from the blue emitter 846 in the EML3 840.

In an alternative embodiment, one of the EML1 640 and the EML3 840 can have different construction. For example, the EML1 640 can include only blue host and blue emitter. In this case, the blue host in the EML1 640 can include a P-type blue host and an N-type blue host, and the blue emitter can include at least one of blue phosphorescent material, blue fluorescent material and blue delayed fluorescent material.

The P-type blue host can include, but is not limited to, an aryl/hetero aryl amine-based organic compound substituted with at least one aromatic group and/or hetero aromatic group, a carbazole-based organic compound and/or a spirofluorene-based organic compound. The N-type blue host can include an azine-based organic compound and/or a benzimidazole-based organic compound.

For example, the blue host in the EML1 640 can include, but is not limited to, 1,3-Bis(carbazol-9-yl)benzene (mCP), 9-(3-(9H-carbazol-9-yl)phenyl)-9H-carbazole-3-carbonitrile (mCP-CN), mCBP, CBP-CN, 9-(3-(9H-Carbazol-9-yl)phenyl)-3-(diphenylphosphoryl)-9H-carbazole (mCPPO1) 3,5-Di(9H-carbazol-9-yl)biphenyl (Ph-mCP), TSPO1, 9-(3'-(9H-carbazol-9-yl)-[1,1'-biphenyl]-3-yl)-9H-pyrido[2,3-b]indole (CzBPCb), Bis(2-methylphenyl)diphenylsilane (UGH-1), 1,4-Bis(triphenylsilyl)benzene (UGH-2), 1,3-Bis(triphenylsilyl)benzene (UGH-3), 9,9-Spirobifluoren-2-yl-diphenyl-phosphine oxide (SPPO1), 9,9'-(5-(Triphenylsilyl)-1,3-phenylene)bis(9H-carbazole) (SimCP), 2-methyl-9,10-bis(naphthalen-2-yl)anthracene (MADN) and/or combinations thereof.

In this case, the contents of the blue host in the EML1 640 can be between about 50 wt% and about 99 wt%, for example, about 80 wt% and about 95 wt%. Further, the contents of the blue emitter in the EML1 640 can be between about 1 wt% and about 50 wt%, for example, about 5 wt% and about 20 wt%, but is not limited thereto. When the EML1 640 includes both the P-type blue host and the N-type blue host, the P-type blue host and the N-type blue host can be admixed with, but is not limited to, a weight ratio of about 4:1 to about 1:4, for example, about 3:1 to about 1:3.

At least one of the EML1 640 and the EML3 840 can include the first hosts 642 and 842 and the second hosts 644 and 844 with controlled energy level so that the OLED D2 with improved luminous properties can be realized. Hereinafter, the OLED D2 where the EML3 840 includes two hosts will be described in more detail.

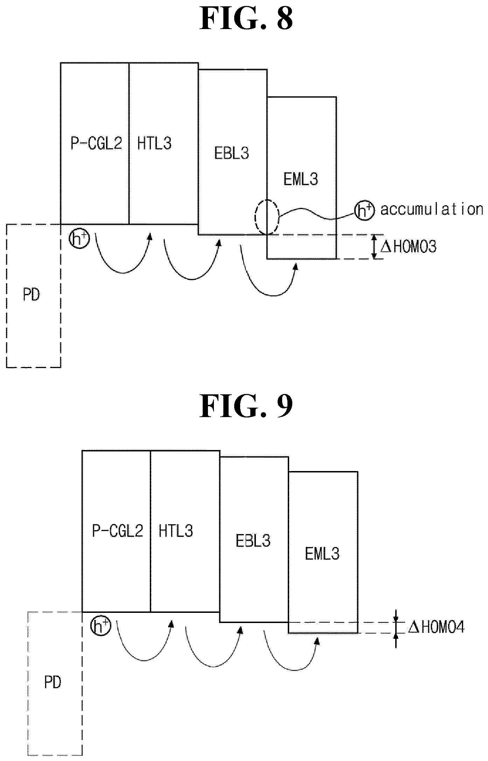

FIG. 8 illustrates a schematic diagram showing energy levels among a common layer and a blue emitting material layer of the emitting unit adjacently to the cathode in a conventional organic light emitting diode with a tandem structure.

As illustrated in FIG. 8, the P-CGL2 784 can include hole transporting material and a P-type dopant PD. The P-type dopant PD takes electrons from the HOMO energy level state of the hole transporting material and induce hole generations in the organic material. Accordingly, the P-type dopant PD has a lowest unoccupied molecular orbital (LUMO) energy level similar to the HOMO energy level of the hole transporting material in the HTL3 820.

As an example, the P-type dopant PD in the P-CGL2 784 has a LUMO energy level between about -5.6 eV and -5.7 eV and the hole transporting material in the P-CGL2 784 and the HTL3 820 has a HOMO energy level between about -5.6 eV and about -5.7 eV. In addition, the electron blocking material in the EBL3 830 has a HOMO energy level between about -5.8 eV in order to transport holes efficiently. On the contrary, the host in the conventional EML3 840 has a HOMO energy level around -6.0 eV.

The energy bandgap ΔHOMO3 between the HOMO energy level of the host in the conventional EML3 840 and the HOMO energy level of the hole transporting material and/or the electron blocking material in the HTL3 820 and/or the EBL3 830 is 0.2 eV or more. The holes generated in the P-CGL2 784 cannot be injected efficiently into the conventional EML3 840, and a portion of the holes generated in the P-CGL2 784 is accumulated in an interface between the blue conventional EML3 840, and the HTL3 820 and/or the EBL3 830.

The luminous efficiency of an organic light emitting diode can be lowered as sufficient excitons are not generated in the conventional EML3 840. In addition, the driving voltage of the organic light emitting diode can be raised as holes not injected into the conventional EML3 840 are quenched as non-emission.

In addition, the holes accumulated in the interface between the conventional EML3 840, and the HTL3 820 and/or the EBL3 830 disposed adjacently to the conventional EML3 840 can cause the hole transporting material and/or the electron blocking material to be deteriorated, and thus, the luminous lifespan of the organic light emitting diode can be reduced.

FIG. 9 illustrates a schematic diagram showing energy levels among a common layer and a blue emitting material layer of the emitting unit adjacently to the cathode in an organic light emitting diode with a tandem structure in accordance with an embodiment of the present invention.

As illustrated in FIGS. 7 and 9, the EML3 840 in the OLED D2 can include the first host 842 and the second host 844. The first host 842 has a HOMO energy level between about -5.9 eV and about -6.1 eV and the second host 844 has a HOMO energy level between about -5.8 eV and about -5.9 eV.

The energy bandgap ΔHOMO4 between the HOMO energy level of the host in EML3 840, and the HOMO energy level of the hole transporting material in the HTL3 820 and/or the electron blocking material in the EBL3 830 can be reduced significantly compared to the energy bandgap ΔHOMO3 between the HOMO energy level of the host in the conventional EML3 840 using the single host, and the HOMO energy level of the hole transporting material and/or the electron blocking material. In one embodiment, the energy bandgap ΔHOMO4 between the HOMO energy level of the host in the EML3 840 including both the first and second hosts 842 and 844, and the HOMO energy level of the hole transporting material and/or the electron blocking material can be about 0.15 eV or less, for example, about 0.1 eV or less.

The holes generated at the P-CGL2 784 can be injected rapidly into the blue EML3 840 via the HTL3 820 and the EBL3 830. Since the holes injected efficiently into the blue EML3 840 can be recombined with electrons to generate effective excitons, the luminous efficiency of the OLED D2 can be improved.

In addition, it is possible to minimize the amount of non-emitting excitons as the excitons are quenched outside of the EML3 840. In this case, excitons are not quenched as non-emissive by TTA and/or TPA. As the exciton quenching in the interface between the EML3 840, and the HTL3 820 and/or the EBL3 830 disposed adjacently to the EML3 840 becomes minimal, it is possible to prevent the driving voltage of the OLED D2 from being raised.

Also, it is possible to minimize the amount of hole accumulations in the interface between the blue EML3 840, and the HTL3 820 and/or the EBL3 830 disposed adjacently to the EML3 840. As the hole transporting material and/or the electron blocking material are not deteriorated owing to the accumulated holes, the luminous lifespan of the OLED D2 can be improved.

Returning to FIG. 7, the EML2 740 includes a first layer 740A disposed between the EBL2 730 and the HBL2 750, a second layer 740B disposed between the first layer 740A and the HBL2 750, and optionally, a third layer 740C disposed between the first layer 740A and the second layer 740B. One of the first layer 740A and the second layer 740B can emit red color light and the other of the first layer 740A and the second layer 740B can emit green color light. Hereinafter, the OLED D2 where the first layer 740A emits red color light and the second layer 740B emits green color light will be described in more detail.

The first layer 740A can include a red host and a red emitter (red dopant), the second layer 740B can include a green host and a green emitter (green dopant) and the third layer 740C can include a yellow-green host and a yellow-green emitter (yellow-green dopant). The red host can include at least one of a P-type red host and an N-type red host, the green host can include at least one of a P-type green host and an N-type green host and the yellow-green host can include at least one of a P-type yellow-green host and an N-type yellow-green host.

Each of the P-type red host, the P-type green host and the P-type yellow-green host can independently include at least one of an amine-based organic compound substituted with at least one aromatic and/or hetero aromatic group, a carbazole-based organic compound and a spirofluorene-based organic compound. Each of the N-type red host, the N-type green host and the N-type yellow-green host can independently include at least one of an azine-based organic compound, a benzimidazole-based organic compound and a quinazoline-based organic compound, but is not limited thereto.

In one embodiment, each of the red host, the green host and the yellow-green host can independently include, but is not limited to, mCP-CN, CBP, mCBP, mCP, DPEPO, 2,8-bis(diphenylphosphoryl)dibenzothiophene (PPT), 1,3,5-Tris[(3-pyridyl)-phen-3-yl]benzene (TmPyPB), 2,6-Di(9H-carbazol-9-yl)pyridine (PYD-2Cz), 2,8-di(9H-carbazol-9-yl)dibenzothiophene (DCzDBT), 3',5'-Di(carbazol-9-yl)-[1,1'-biphenyl]-3,5-dicarbonitrile (DCzTPA), 4'-(9H-carbazol-9-yl)biphenyl-3,5-dicarbonitrile (pCzB-2CN), 3'-(9H-carbazol-9-yl)biphenyl-3,5-dicarbonitrile (mCzB-2CN), TSPO1, 9-(9-phenyl-9H-carbazol-6-yl)-9H-carbazole (CCP), 4-(3-(triphenylen-2-yl)phenyl)dibenzo[b,d]thiophene, 9-(4-(9H-carbazol-9-yl)phenyl)-9H-3,9'-bicarbazole, 9-(3-(9H-carbazol-9-yl)phenyl)-9H-3,9'-bicarbazole, 9-(6-(9H-carbazol-9-yl)pyridin-3-yl)-9H-3,9'-bicarbazole, 9,9'-Diphenyl-9H,9'H-3,3'-bicarbazole (BCzPh), 1,3,5-Tris(carbazol-9-yl)benzene (TCP), TCTA, 4,4'-Bis(carbazole-9-yl)-2,2'-dimethylbiphenyl (CDBP), 2,7-Bis(carbazole-9-yl)-9,9-dimethylfluorene (DMFL-CBP), 2,2',7,7'-Tetrakis(carbazol-9-yl)-9,9-spirofluorene (Spiro-CBP), 3,6-Bis(carbazole-9-yl)-9-(2-ethyl-hexyl)-9H-carbazole (TCz1), BPBPA, 1,3,5-Tris(N-phenylbenzimidazol-2-yl)benzene (TPBi) and/or combinations thereof.

The red emitter in the first layer 740A can include at least one of red phosphorescent material, red fluorescent material and red delayed fluorescent material. For example, the red emitter can include, but is not limited to, Bis[2-(4,6-dimethyl)phenylquinoline](2,2,6,6-tetramethylheptane-3,5-dionate)iridium(III), Bis[2-(4-n-hexylphenyl)quinoline](acetylacetonate)iridium(III) (Hex-Ir(phq)₂(acac)), Tris[2-(4-n-hexylphenyl)quinoline]iridium(III) (Hex-Ir(phq)₃), Tris[2-phenyl-4-methylquinoline]iridium(III) (Ir(Mphq)₃), Bis(2-phenylquinoline)(2,2,6,6-tetramethylheptene-3,5-dionate)iridium(III) (Ir(dpm)PQ₂), Tris(1-phenylisoquinoline)iridium(III) (Ir(piq)₃), Bis(phenylisoquinoline)(2,2,6,6-tetramethylheptene-3,5-dionate)iridium(III) (Ir(dpm)(piq)₂), Bis(1-phenylisoquinoline)(acetylacetonate)iridium(III) (Ir(piq)₂(acac)), Bis[(4-n-hexylphenyl)isoquinoline](acetylacetonate)iridium(III) (Hex-Ir(piq)₂(acac)), Tris[2-(4-n-hexylphenyl)quinoline]iridium(III) (Hex-Ir(piq)₃), Tris(2-(3-methylphenyl)-7-methyl-quinolato)iridium (Ir(dmpq)₃), Bis[2-(2-methylphenyl)-7-methylquinoline](acetylacetonate)iridium(III) (Ir(dmpq)₂(acac)), Bis[2-(3,5-dimethylphenyl)-4-methylquinoline](acetylacetonate)iridium(III) (Ir(mphmq)₂(acac)), Tris(dibenzoylmethane)mono(1,10-phenanthroline)europium(III) (Eu(dbm)₃(phen)) and/or combinations thereof.

The green emitter in the second layer 740B can include at least one of green phosphorescent material, green fluorescent material and green delayed fluorescent material. For example, the green emitter can include, but is not limited to, [Bis(2-phenylpyridine)](pyridyl-2-benzofuro[2,3-b]pyridine)iridium, Tris[2-phenylpyridine]iridium(III) (Ir(ppy)₃), fac-Tris(2-phenylpyridine)iridium(III) (fac-Ir(ppy)₃), Bis(2-phenylpyridine)(acetylacetonate)iridium(III) (Ir(ppy)₂(acac)), Tris[2-(p-tolyl)pyridine]iridium(III) (Ir(mppy)₃), Bis(2-(naphthalene-2-yl)pyridine)(acetylacetonate)iridium(III) (Ir(npy)₂acac), Tris(2-phenyl-3-methyl-pyridine)iidium (Ir(3mppy)₃), fac-Tris(2-(3-p-xylyl)phenyl)pyridine iridium(III) (TEG) and/or combinations thereof.

The yellow-green emitter in the third layer 740C can include at least one of yellow-green phosphorescent material, yellow-green fluorescent material and yellow-green delayed fluorescent material. For example, the yellow-green emitter can include, but is not limited to, 5,6,11,12-Tetraphenylnaphthalene (Rubrene), 2,8-Di-tert-butyl-5,11-bis(4-tert-butylphenyl)-6,12-diphenyltetracene (TBRb), Bis(2-phenylbenzothiazolato)(acetylacetonate)irdium(III) (Ir(BT)₂(acac)), Bis(2-(9,9-diethyl-fluoren-2-yl)-1-phenyl-1H-benzo[d]imdiazolato)(acetylacetonate)iridium(III) (Ir(fbi)₂(acac)), Bis(2-phenylpyridine)(3-(pyridine-2-yl)-2H-chromen-2-onate)iridium(III) (fac-Ir(ppy)₂Pc), Bis(2-(2,4-difluorophenyl)quinoline)(picolinate)iridium(III) (FPQIrpic), Bis(4-phenylthieno[3,2-c]pyridinato-N,C2') (acetylacetonate) iridium(III) (PO-01) and/or combinations therreof. In certain embodiments, the third layer 740C can be omitted.

The contents of the host in each of the first layer 740A, the second layer 740B and the third layer 740C can be between about 50 wt% to about 99 wt%, for example, about 95 wt% to about 98 wt%, respectively, and the contents of the emtter in each of the first layer 740A, the second layer 740B and the third layer 740C can be between about 1 wt% to about 50 wt%, for example, about 2 wt% to about 5 wt%, respectively, but is not limited thereto. When each of the first layer 740A, the second layer 740B and the third layer 740C includes the P-type host and the N-type host, respectively, the P-type host and the N-type host can be admixed with, but is not limited to, weight ratio of about 4:1 to about 1:4, for example, about 3:1 to about 1:3.

At least one of the EML1 640 and the EML3 840 includes the first host 642 or 842 and the seocnd host 644 or 844 so that the OLED D2 with beneficial luminous property can be realized. The OLED D2 has a tandem structure so that the color purity and luminous property of the OLED D2 can be further improved.

### Example 1 (Ex.1): Fabrication of OLED (not forming part of the invention)

An organic light emitting diode where a blue emitting material layer in the first emitting part disposed adjacently to an anode includes a first host and a second host was fabricated.

A glass substrate onto which ITO (1200 Å) was coated as a thin film was washed and ultrasonically cleaned by solvent such as isopropyl alcohol, acetone and dried at 100°C oven. The substrate was transferred to a vacuum chamber for depositing emissive layer as the following order:

Hole injection layer (HIL, DNTPD (50 wt%), MgF₂ (50 wt%), 70 Å); first hole transport layer (HTL1, DNTPD (HOMO: -5.58 eV, LUMO: -2.52 eV), 1000 Å); first electron blocking layer (EBL1, TCTA (HOMO: -5.8 eV, LUMO: -2.61 eV), 150 Å); first blue emitting material layer (B-EML1, Host (first host MADN (HOMO: -6.0 eV, LUMO: -3.0 eV) and second host Compound BH2-1 of Chemical Formula 4 (HOMO: -5.8 eV, LUMO: -2.8 eV) by weight ratio of 9:1, 95 wt%), DABNA-1 (5 wt%), 200 Å); first electron transport layer (ETL1, ZADN, 110 Å); first N-type charge generation layer (N-CGL1, Bphen (98 wt%), Li (2 wt%), 130 Å); first P-type charge generation layer (P-CGL1, DNTPD (90 wt%), P-type dopant (10 wt%), 70 Å); second hole transport layer (HTL2, BPBPA, 70 Å); red emitting material layer (R-EML, host (BPBPA and TPBi by weight ratio of 5:5, 95 wt%), Ir(piq)₂acac (5 wt%), 100 Å); yellow-green emitting material layer (YG-EML, host (CBP and TPBi by weight ratio of 5:5, 85 wt%), PO-01 (15 wt%), 100 Å); green emitting material layer (G-EML, host (CBP and TPBi by weight ratio of 5:5, 85 wt%), Ir(ppy)₃ (15 wt%), 200 Å); second electron transport layer (ETL2, TPBi, 200 Å); second N-type charge generation layer (N-CGL2, Bphen (97 wt%), Li (3 wt%), 200 Å); second P-type charge generation layer (P-CGL2, DNDPD (80 wt%), P-type dopant (20 wt%), 100 Å); third hole transport layer (HTL3, DNTPD, 500 Å); second electron blocking layer (EBL2, TCTA, 150 Å); second blue emitting material layer (B-EML2, MADN (95 wt%), DABNA-1 (5 wt%), 300 Å); third electron transport layer (ETL3, ZADN, 200 Å); electron injection layer (EIL, LIF, 15 Å); and cathode (Al, 100 Å).

The fabricated OLED was encapsulated with glass and then transferred from the deposition chamber to a dry box in order to form a film. And then, the OLED was encapsulated with UV-cured epoxy resin and water getter. The structures of materials of hole injecting material, hole transporting material, blue emitter, red host, red emitter, yellow-green emitter, green emitter and electron transporting material are illustrated in the following:

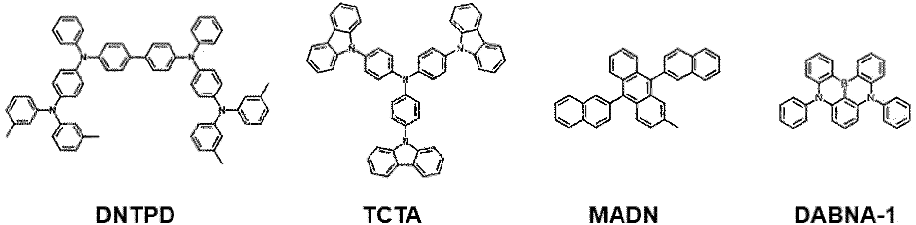

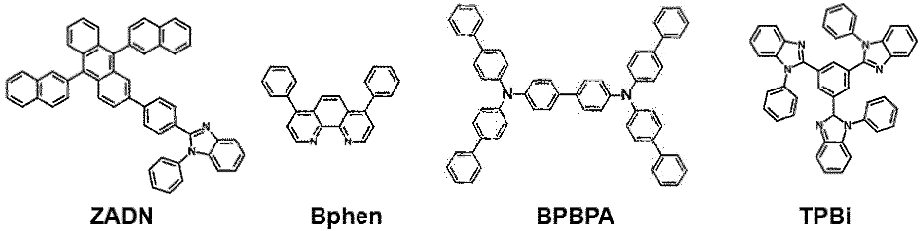

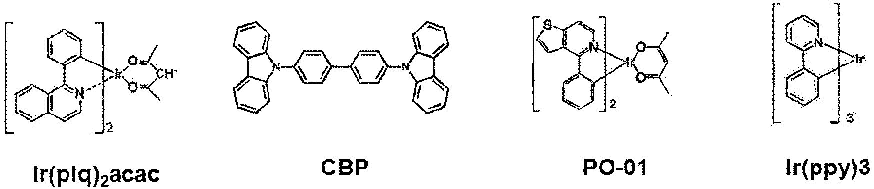

### Example 2 (Ex. 2): Fabrication of OLEDs (not forming part of the invention)

An OLED was fabricated using the same procedure and the same material as Example 1, except that the first host MADN and the second host Compound BH2-1 in the first blue emitting material layer was admixed with a weight ratio of 8:2.

### Example 3 (Ex. 3): Fabrication of OLEDs (not forming part of the invention)

An OLED was fabricated using the same procedure and the same material as Example 1, except that the first host MADN and the second host Compound BH2-1 in the first blue emitting material layer was admixed with a weight ratio of 7:3.

### Example 4 (Ex. 4): Fabrication of OLEDs (not forming part of the invention)

An OLED where the second blue emitting material layer of the third emitting unit disposed adjacently to the cathode includes a first host and a second host was fabricated. The OLED was fabricated using the same procedure and the same material as Example 1, except that the first blue emitting material layer included only the first host MADN (95 wt%) and blue emitter DABNA-1 (5 wt%), and the second emitting material layer included host (first host MADN and the second host Compound BH2-1 by weight ratio 9: 1, 95 wt%) and the blue emitter DABNA-1 (5 wt%).

### Example 5 (Ex. 5): Fabrication of OLEDs (not forming part of the invention)

An OLED was fabricated using the same procedure and the same material as Example 4, except that the first host MADN and the second host Compound BH2-1 in the second blue emitting material layer was admixed with a weight ratio of 8:2.

### Example 6 (Ex. 6): Fabrication of OLEDs (not forming part of the invention)

An OLED was fabricated using the same procedure and the same material as Example 1, except that the first host MADN and the second host Compound BH2-1 in the second blue emitting material layer was admixed with a weight ratio of 7:3.

### Comparative Example 1(Ref. 1): Fabrication of OLEDs

An OLED was fabricated using the same procedure and the same material as Example 1, except that both the first blue emitting material layer and the second blue emitting material layer included only the first host MADN (95 wt%) and the blue emitter DABNA-1 ( 5 wt%).

### Experimental Example 1: Measurement of Luminous Properties of OLEDs

The luminous properties for each of the OLEDs, fabricated in Examples 1 to 6 and Comparative Example 1, were measured. Each of the OLEDs were connected to an external power source and then luminous properties for all the OLEDs were evaluated using a constant current source (KEITHLEY) and a photometer PR650 at room temperature. In particular, driving voltage (V, relative value), External quantum efficiency (EQE, relative value) at a current density of 10 mA/cm², time period (LT₉₅, relative value) at which the luminance of the red color light was reduced to 95% from initial luminance was measured at a current density 40 mA/cm² and at 40°C. The measurement results are indicated in the following Table 1.

**Table 1: Properties of OLED**

| Sample | @10 mA/cm² | | | @40°C, 40 mA/cm² |
|---|---|---|---|---|
| | Voltage (V) (Relative) | Voltage (V) @100J (Relative) | EQE (Relative) | LT₉₅ (%) |
| Ref. 1 | 0 | 0 | 100% | 100% |
| Ex. 1 | 0 | -0.02 | 100% | 100.5% |
| Ex. 2 | -0.16 | -0.18 | 99% | 102% |
| Ex. 3 | -0.20 | -0.23 | 96% | 85% |
| Ex. 4 | -0.05 | -0.12 | 100% | 110% |
| Ex. 5 | -0.15 | -0.17 | 99.7% | 140% |
| Ex. 6 | -0.19 | -0.21 | 97% | 135% |

As indicated in Table 1, compared to the OLED fabricated in Comparative Example 1 where both the first and second blue emitting material layers include only the first host with relatively low HOMO energy level, in the OLEDs fabricated in Examples 1-6 where the blue emitting material layer includes the first host and the second host, the driving voltage was lowered to realize low power consumption. In addition, compared to the OLED fabricated in Comparative Example 1, in the OLED fabricated in Ex. 1-6, the luminous lifespan was improved by maximally 40% with maintaining EQE of equivalent level.

Particularly, as in Examples 4-6, when the second blue emitting material layer in the third emitting part, which receives holes from the second P-type charge generation layer, disposed adjacently to the cathode, includes the first host and the second host, luminous lifespan of the OLED was improved significantly. In addition, when the contents of the second host in the blue emitting material layer was designed to be between 10 wt% and 20 wt%, the luminous lifespan can be maximized with maintaining EQE.

### Example 7 (Ex.7): Fabrication of OLED (not forming part of the invention)

An organic light emitting diode where a blue emitting material layer in a single emitting unit includes a first host and a second host was fabricated. As Example 1, on the ITO transparent electrode coated onto the glass substrate, organic layer was deposited as the following order:

Hole injection layer (HIL, DNTPD (80 wt%), P-type dopant (20 wt%), 100 Å); hole transport layer (HTL, DNTPD, 1000 Å); electron blocking layer (EBL, TCTA, 50 Å); blue emitting material layer (B-EML, Host (first host MADN and second host Compound BH2-1 of Chemical Formula 4 by weight ratio of 8:2, 95 wt%), DABNA-1 (5 wt%), 300 Å); electron transport layer (ETL, ZADN, 200 Å); electron injection layer (EIL, LIF, 15 Å); and cathode (Al, 100 Å).

### Examples 8-13 (Ex. 8-13): Fabrication of OLEDs (not forming part of the invention)

An OLED was fabricated using the same procedure and the same material as Example 7, except that Compound BH2-2 (Ex. 8), Compound BH2-3 (Ex. 9), Compound BH2-4 (Ex. 10), Compound BH2-5 (Ex. 11), Compound BH2-6 (Ex. 12) and Compound BH2-7 (Ex. 13) of Chemical Formula 4 instead of Compound BH2-1 as the second host in the blue emitting material was used, respectively.

### Comparative Example 2(Ref. 2): Fabrication of OLEDs

An OLED was fabricated using the same procedure and the same material as Example 7, except that both the first blue emitting material layer and the second blue emitting material layer included only the first host MADN (95 wt%) and the blue emitter DABNA-1 ( 5 wt%).

### Experimental Example 2: Measurement of Luminous Properties of OLEDs

The luminous properties for each of the OLEDs, fabricated in Examples 7 to 13 and Comparative Example 2, were measured as Experimental Example 1. The measurement results are indicated in the following Table 2.

**Table 2: Properties of OLED**

| Sample | @10 mA/cm² | | | @40°C, 40 mA/cm² |
|---|---|---|---|---|
| | Voltage (V) (Relative) | Voltage (V) @100J (Relative) | EQE (Relative) | LT₉₅ (%) |
| Ref. 2 | 0 | 0 | 100% | 100% |
| Ex. 7 | -0.06 | -0.08 | 99.3% | 136% |
| Ex. 8 | -0.19 | -0.14 | 94.5% | 142% |
| Ex. 9 | -0.12 | -0.06 | 100.7% | 144% |
| Ex. 10 | -0.04 | 0.02 | 100.5% | 138% |
| Ex. 11 | 0.03 | 0.09 | 98.4% | 132% |
| Ex. 12 | -0.06 | -0.09 | 98.8% | 146% |
| Ex. 13 | -0.13 | -0.18 | 96.2% | 178% |

As indicated in Table 2, compared to the OLED fabricated in Comparative Example 2, in the OLEDs fabricated in Examples 7-13, the driving voltage was lowered, and EQE and luminous lifespan was improved significantly. In particular, as in Example 13, when the second host substituted with deuterium was used together with the first host, the luminous lifespan was greatly improved.

It will be apparent to those skilled in the art that various modifications and variations can be made in the present invention without departing from the scope of the invention. Thus, it is intended that the present invention cover the modifications and variations of the present invention provided they come within the scope of the appended claims.

## Claims

1. An organic light emitting diode (D1, D2), comprising:
a first electrode (210, 510);
a second electrode (220, 520) facing the first electrode (210, 510); and
an emissive layer (230, 530) disposed between the first and second electrode (210, 220, 510 520), and including at least one blue emitting material layer (340, 640, 840),
and a second host (344)
wherein the at least one blue emitting material layer (340, 640, 840) includes a first host (342, 642, 842) and a second host (344, 644, 844),
**characterised in that**
the first host (342, 642, 842) and the second host (344, 644, 844) in the at least one blue emitting material layers (340) are admixed with a weight ratio of 9:1 to 7:3
the first host (342, 642, 842) is at least one of the following organic compounds: 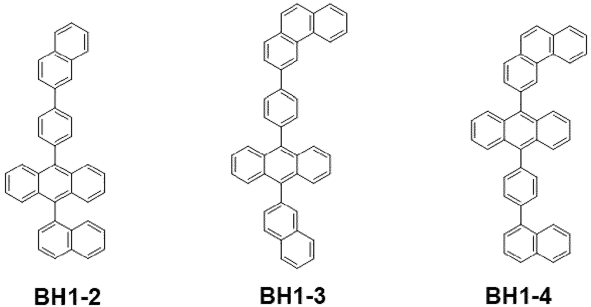 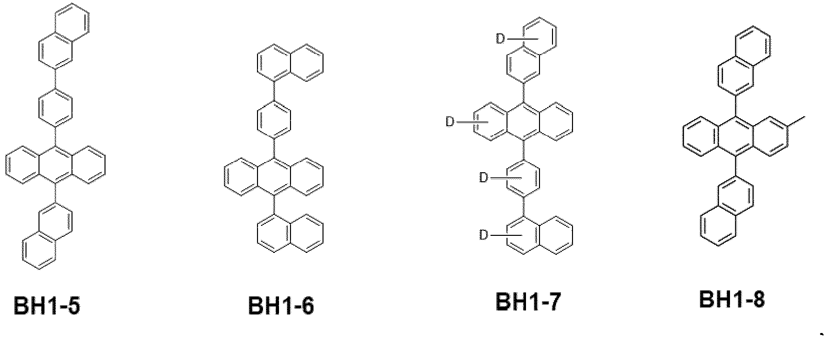 and
the second host (344, 644, 844) is at least one of the following organic compounds:

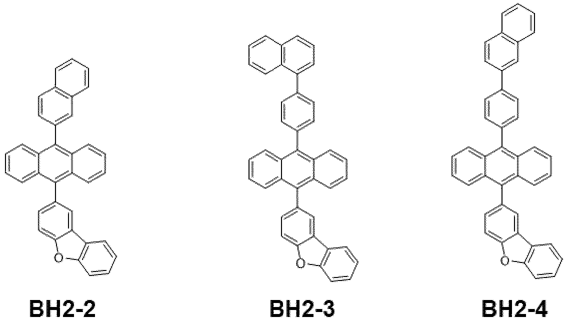

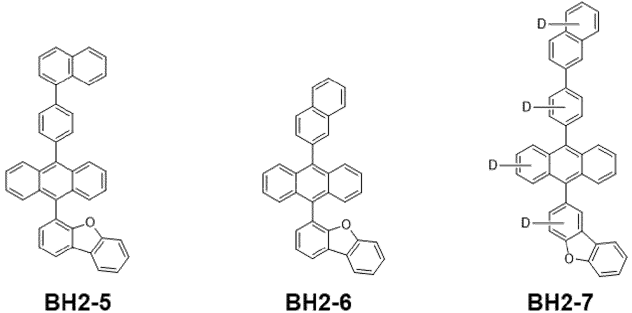

2. The organic light emitting diode (D2) of claim 1, wherein the emissive layer comprises:
a first emitting part (600) disposed between the first electrode (510) and the second electrode (520), and including a first blue emitting material layer (640);
a second emitting part (700) disposed between the first emitting part (600) and the second electrode (520);
a third emitting part (800) disposed between the second emitting part (700) and the second electrode (520), and including a second blue emitting material layer (840);
a first charge generation layer (680) disposed between the first emitting part (600) and the second emitting part (700); and
a second charge generation layer (780) disposed between the second emitting part (700) and the third emitting part (800), and
wherein at least one of the first blue emitting material layer (640) and the second blue emitting material layer (840) includes the first host (642, 842) and the second host (644, 844).

3. The organic light emitting diode (D2) of claim 2, wherein the first blue emitting material layer 640 and the second blue emitting material layer (840) include the first host (642, 842) and the second host (644, 844).

4. An organic light emitting device (100, 400), comprising:
a substrate (102, 402); and
the organic light emitting diode (D) of any one of claims 1 to 3 over the substrate.

## Patentansprüche

1. Organische Leuchtdiode (D1, D2), die umfasst:
eine erste Elektrode (210, 510);
eine zweite Elektrode (220, 520), die der ersten Elektrode (210, 510) zugewandt ist; und
eine Emissionsschicht (230, 530), die zwischen der ersten und der zweiten Elektrode (210, 220, 510, 520) angeordnet ist und mindestens eine blau emittierende Materialschicht (340, 640, 840) umfasst,
und einen zweiten Wirt (344),
wobei die mindestens eine blau emittierende Materialschicht (340, 640, 840) einen ersten Wirt (342, 642, 842) und einen zweiten Wirt (344, 644, 844) umfasst,
**dadurch gekennzeichnet, dass**
der erste Wirt (342, 642, 842) und der zweite Wirt (344, 644, 844) in der mindestens einen blau emittierenden Materialschicht (340) mit einem Gewichtsverhältnis von 9:1 bis 7:3 vermischt sind,
der erste Wirt (342, 642, 842) mindestens eine der folgenden organischen Verbindungen ist: 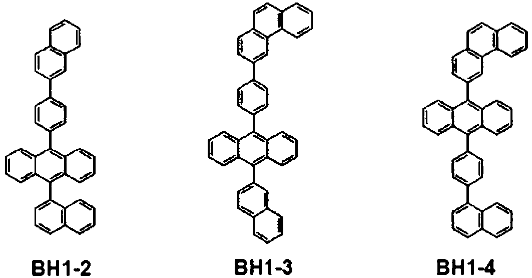 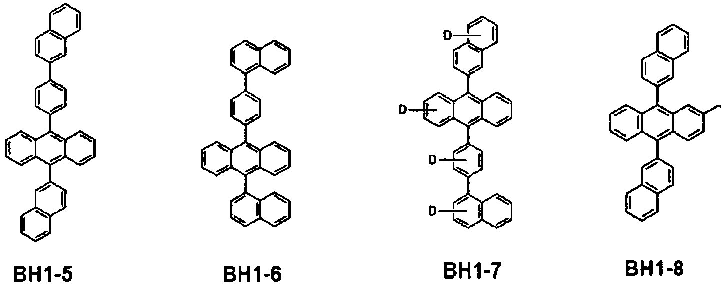 und
der zweite Wirt (344, 644, 844) mindestens eine der folgenden organischen Verbindungen ist:

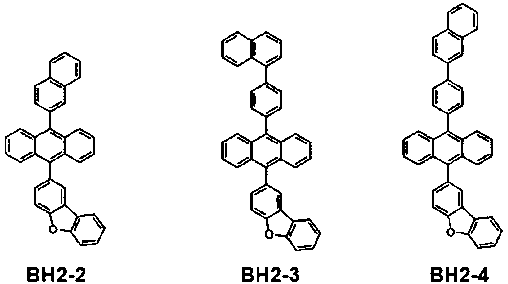

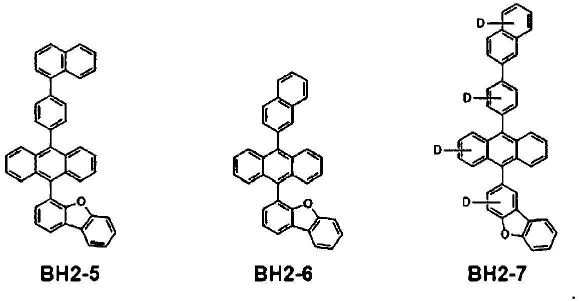

2. Organische Leuchtdiode (D2) nach Anspruch 1, wobei die Emissionsschicht umfasst:
einen ersten Emissionsteil (600), der zwischen der ersten Elektrode (510) und der zweiten Elektrode (520) angeordnet ist und eine erste blau emittierende Materialschicht (640) umfasst;
einen zweiten Emissionsteil (700), der zwischen dem ersten Emissionsteil (600) und der zweiten Elektrode (520) angeordnet ist;
einen dritten Emissionsteil (800), der zwischen dem zweiten Emissionsteil (700) und der zweiten Elektrode (520) angeordnet ist und eine zweite blau emittierende Materialschicht (840) umfasst;
eine erste Ladungserzeugungsschicht (680), die zwischen dem ersten Emissionsteil (600) und dem zweiten Emissionsteil (700) angeordnet ist; und
eine zweite Ladungserzeugungsschicht (780), die zwischen dem zweiten Emissionsteil (700) und dem dritten Emissionsteil (800) angeordnet ist;
wobei mindestens eine der ersten blau emittierenden Materialschicht (640) und der zweiten blau emittierenden Materialschicht (840) den ersten Wirt (642, 842) und den zweiten Wirt (644, 844) enthält.

3. Organische Leuchtdiode (D2) nach Anspruch 2, wobei die erste blau emittierende Materialschicht 640 und die zweite blau emittierende Materialschicht (840) den ersten Wirt (642, 842) und den zweiten Wirt (644, 844) enthalten.

4. Organische Lichtemissionsvorrichtung (100, 400), die umfasst:
ein Substrat (102, 402); und
die organische Leuchtdiode (D) nach einem der Ansprüche 1 bis 3 über dem Substrat.

## Revendications

1. Diode électroluminescente organique (D1, D2), comportant :
une première électrode (210, 510) ;
une seconde électrode (220, 520) dirigée vers la première électrode (210, 510) ; et
une couche émissive (230, 530) disposée entre les première et seconde électrodes (210, 220, 510, 520), et incluant au moins une couche de matériau émetteur de bleu (340, 640, 840),
et un second hôte (344)
dans laquelle la au moins une couche de matériau émetteur de bleu (340, 640, 840) inclut un premier hôte (342, 642, 842) et un second hôte (344, 644, 844),
**caractérisée en ce que**
le premier hôte (342, 642, 842) et le second hôte (344, 644, 844) dans la au moins une couche de matériau émetteur de bleu (340) sont mélangés avec un rapport pondéral de 9:1 à 7:3
le premier hôte (342, 642, 842) est au moins un des composés organiques suivants : 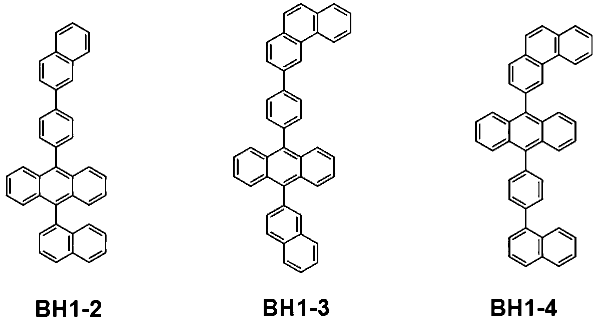 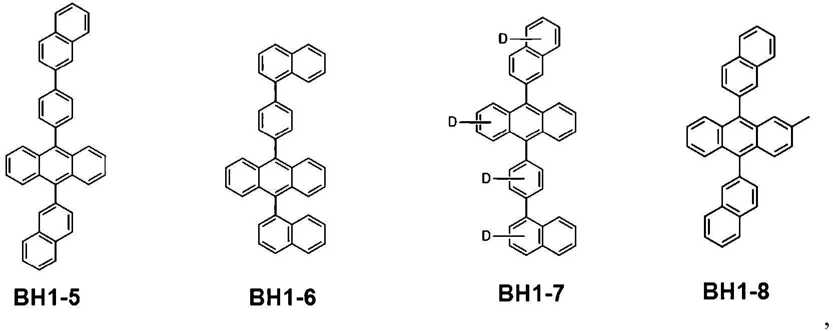 et
le second hôte (344, 644, 844) est au moins un des composés organiques suivants :

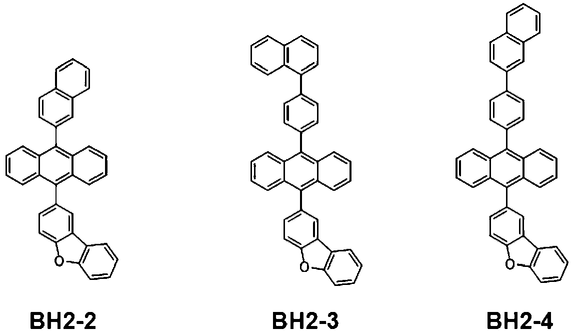

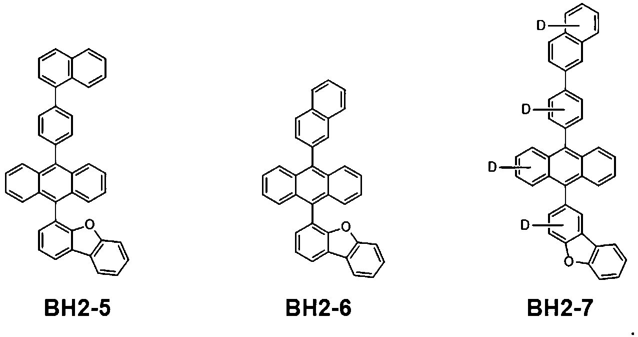

2. Diode électroluminescente organique (D2) selon la revendication 1, dans laquelle la couche émissive comporte :
une première partie émettrice (600) disposée entre la première électrode (510) et la seconde électrode (520), et incluant une première couche de matériau émetteur de bleu (640) ;
une deuxième partie émettrice (700) disposée entre la première partie émettrice (600) et la seconde électrode (520) ;
une troisième partie émettrice (800) disposée entre la deuxième partie émettrice (700) et la seconde électrode (520), et incluant une seconde couche de matériau émetteur de bleu (840) ;
une première couche de génération de charges (680) disposée entre la première partie émettrice (600) et la deuxième partie émettrice (700) ; et
une seconde couche de génération de charges (780) disposée entre la deuxième partie émettrice (700) et la troisième partie émettrice (800), et
dans laquelle au moins une couche parmi la première couche de matériau émetteur de bleu (640) et la seconde couche de matériau émetteur de bleu (840) inclut le premier hôte (642, 842) et le second hôte (644, 844).

3. Diode électroluminescente organique (D2) selon la revendication 2, dans laquelle la première couche de matériau émetteur de bleu (640) et la seconde couche de matériau émetteur de bleu (840) incluent le premier hôte (642, 842) et le second hôte (644, 844).

4. Dispositif électroluminescent organique (100, 400), comportant :
un substrat (102, 402) ; et
la diode électroluminescente organique (D) selon l'une quelconque des revendications 1 à 3 au-dessus du substrat.
